(19) Europäisches Patentamt
European Patent Office
Office européen des brevets

(11) **EP 2 415 079 B1**

(12) **FASCICULE DE BREVET EUROPEEN**

(45) Date de publication et mention de la délivrance du brevet:
**07.09.2016 Bulletin 2016/36**

(21) Numéro de dépôt: **10712438.0**

(22) Date de dépôt: **01.04.2010**

(51) Int Cl.:
*H01L 21/84* [(2006.01)]     *H01L 29/786* [(2006.01)]
*H01L 27/12* [(2006.01)]     *H01L 21/8244* [(2006.01)]
*H01L 21/336* [(2006.01)]     *H01L 21/8238* [(2006.01)]
*H01L 27/11* [(2006.01)]     *H01L 27/092* [(2006.01)]

(86) Numéro de dépôt international:
**PCT/EP2010/054415**

(87) Numéro de publication internationale:
**WO 2010/112585 (07.10.2010 Gazette 2010/40)**

(54) **CIRCUIT INTEGRE REALISE EN SOI PRESENTANT DES TRANSISTORS A TENSIONS DE SEUIL DISTINCTES**

INTEGRIERTER SOI-SCHALTKREIS MIT TRANSISTOREN MIT SEPARATEN SCHWELLENSPANNUNGEN

INTEGRATED CIRCUIT ON SOI HAVING TRANSISTORS WITH SEPARATE THRESHOLD VOLTAGES

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **01.04.2009 FR 0901595**

(43) Date de publication de la demande:
**08.02.2012 Bulletin 2012/06**

(73) Titulaire: **Commissariat à l'Énergie Atomique et aux Énergies Alternatives**
**75015 Paris (FR)**

(72) Inventeurs:
• **THOMAS, Olivier**
  **F-38420 Revel (FR)**
• **NOEL, Jean-Philippe**
  **F-38000 Grenoble (FR)**

(74) Mandataire: **Guérin, Jean-Philippe et al**
**Opilex**
**310 avenue Berthelot**
**69008 Lyon (FR)**

(56) Documents cités:
**US-A- 6 063 686**

• KAWAHARA T: "Low-voltage embedded RAMs in nanometer era" IEICE TRANSACTIONS ON ELECTRONICS INST. ELECTRON. INF. & COMMUN. ENG JAPAN, vol. e90c, no. 4, avril 2007 (2007-04), pages 735-742, XP002547480 ISSN: 0916-8524
• YAMAOKA ET AL: "SRAM Circuit With Expanded Operating Margin and Reduced Stand-By Leakage Current Using Thin-BOX FD-SOI Transistors" IEEE JOURNAL OF SOLID-STATE CIRCUITS, IEEE SERVICE CENTER, PISCATAWAY, NJ, US, vol. 41, no. 11, 1 novembre 2006 (2006-11-01), pages 2366-2372, XP011149834 ISSN: 0018-9200
• GALLON C ET AL: "Ultra-thin fully depleted SOI devices with thin BOX, ground plane and strained liner booster" 2006 IEEE INTERNATIONAL SOI CONFERENCE (IEEE CAT. NO. 06CH37786) IEEE PISCATAWAY, NJ, USA, 2006, pages 17-18, XP002547481 ISBN: 0-4244-0289-1
• SAIBAL MUKHOPADHYAY ET AL: "Device Design and Optimization Methodology for Leakage and Variability Reduction in Sub-45-nm FD/SOI SRAM" IEEE TRANSACTIONS ON ELECTRON DEVICES, IEEE SERVICE CENTER, PISACATAWAY, NJ, US, vol. 54, no. 1, 1 janvier 2008 (2008-01-01), pages 152-162, XP011199361 ISSN: 0018-9383

- **KEUNWOO KIM; KUANG J B; GEBARA F; NGO H C; CHING-TE CHUANG; NOWKA K J: "Stable high-density FD/SOI SRAM with selective back-gate bias using dual buried oxide" 2008 IEEE INTERNATIONAL SOI CONFERENCE PROCEEDINGS, 6 octobre 2008 (2008-10-06), - 9 octobre 2008 (2008-10-09) pages 37-38, XP002547482 Piscataway, NJ, USA**

- **GIRAUD B ET AL: "In-depth analysis of 4T SRAM cells in double-gate CMOS" 2007 INTERNATIONAL CONFERENCE ON INTEGRATED CIRCUIT DESIGN AND TECHNOLOGY IEEE PISCATAWAY, NJ, USA, 2007, pages 265-268, XP002547483 ISBN: 1-4244-0757-5**

**Description**

L'invention concerne les circuits intégrés, et en particulier les circuits intégrés réalisés sur un substrat de type silicium sur isolant (SOI). La technologie SOI consiste à séparer une fine couche de Silicium (quelques dizaines de nm) d'un substrat en Silicium par une couche d'isolant relativement épaisse (quelques centaines de nanomètres en règle générale).

Les circuits intégrés réalisés en technologie SOI présentent un certain nombre d'avantages. De tels circuits présentent généralement une plus faible consommation électrique pour des performances équivalentes. De tels circuits induisent également des capacités parasites plus faibles, qui permettent d'améliorer la vitesse de commutation. De plus, le phénomène de déclenchement parasite (latchup en langue anglaise) rencontré par les transistors CMOS en technologie Bulk peut être évité. De tels circuits s'avèrent donc particulièrement adaptés pour des applications de type SOC ou MEMS. On constate également que les circuits SOI sont moins sensibles aux effets des radiations ionisantes et s'avèrent ainsi plus fiables dans des applications où de telles radiations peuvent induire des problèmes de fonctionnement, notamment des applications spatiales. Les circuits intégrés SOI réalisés peuvent notamment comprendre des mémoires vives de type SRAM ou des portes logiques.

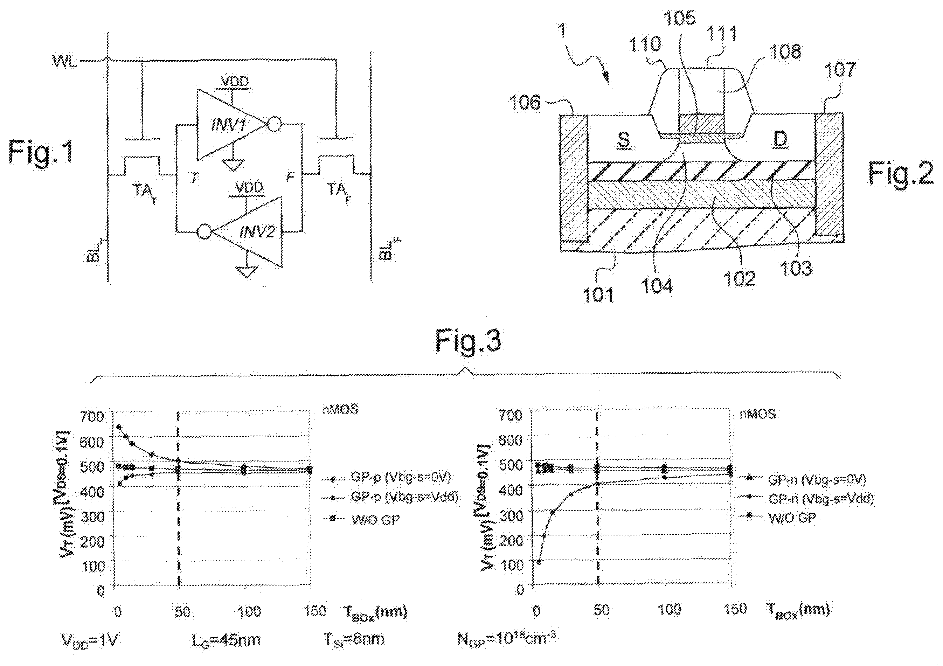

Comme illustré à la figure 1, une cellule mémoire SRAM se compose de deux inverseurs Inv1 et Inv2 connectés en configuration bascule bistable et de deux transistors d'accès TAT et TAF connectés à des lignes de bits BLT et BLF. Les transistors d'accès TAT et TAF sont commandés par une ligne de mot WL. Les exigences auxquelles doit répondre la cellule mémoire sont :

une stabilité suffisante garantissant le fonctionnement de la cellule lors des opérations de lecture, écriture ou rétention ;
un courant de conduction maximal pour accroître la rapidité d'accès à la cellule;
une taille de cellule minimale pour accroître la densité d'intégration ; et
un courant de rétention minimal pour réduire la consommation électrique en statique.

Deux types de cellules mémoire sont développés concurremment. Un premier type de mémoire dit 4T utilise deux transistors de conduction pour former les inverseurs de la bascule bistable. La figure 4 du brevet US 6 442 060 illustre un exemple de cellule mémoire SRAM réalisée selon cette architecture. Cependant, bien que cette architecture de cellule mémoire permette théoriquement d'obtenir une très forte densité, la présence de noeuds internes flottants implique un compromis de dimensionnement entre les exigences de stabilité en lecture et de stabilité en rétention. Afin d'accroître la stabilité en lecture et en rétention, plusieurs études proposent des circuits dynamiques contrôlant individuellement les transistors des cellules mémoire. La densité de cellules d'une mémoire réalisée en architecture 4T s'avère alors en pratique relativement réduite, ce qui rend encore cette architecture d'un intérêt industriel relativement limité.

Un second type de mémoire dit 6T utilise quatre transistors pour former les inverseurs. La figure 2 du brevet US6 442 060 illustre un exemple de cellule mémoire SRAM réalisée selon cette architecture. Certains circuits mémoire doivent intégrer à la fois des cellules mémoire favorisant la rapidité d'accès aux noeuds de stockage et des cellules mémoire favorisant une consommation électrique réduite en rétention.

De tels circuits mémoire s'avèrent délicats à réaliser, la topologie et la conception des deux types de mémoire étant radicalement différentes pour que chacune présente soit une bonne rapidité d'accès soit une consommation réduite en rétention.

Pour des technologies de gravure à 45nm ou moins, Il devient délicat d'accroître la densité de cellules tout en conservant de bonnes marges au bruit à la fois en lecture et en écriture. Les dispersions de fabrication sur les paramètres électriques du transistor deviennent plus critiques avec des gravures de plus en plus fines, ce qui accroît la sensibilité des circuits intégrés face à différentes sources de bruit : couplage capacitif, couplage inductif, bruit d'alimentation...

La réduction de la consommation statique de portes logiques tout en augmentant leur vitesse de basculement fait également l'objet de nombreuses recherches. Certains circuits intégrés en cours de développement intègrent à la fois des portes logiques à faible consommation et des portes logiques à vitesse de basculement élevée. Pour générer ces deux types de portes logiques sur un même circuit intégré, on rabaisse la tension de seuil de certains transistors des portes logiques à accès rapide, et on augmente la tension seuil d'autres transistors des portes logiques à faible consommation. En technologie Bulk, la modulation du niveau de tension de seuil de transistors de même type est effectuée en différenciant le niveau de dopage de leur canal. Cependant, en technologie FDSOI (pour Fully Depleted Silicium On Isolant en langue anglaise, désignant du Silicium sur isolant totalement déplété), le dopage du canal est quasiment nul. Ainsi, le niveau de dopage du canal des transistors ne peut donc pas présenter de variations importantes, ce qui empêche de différencier les tensions de seuil par ce biais. Une solution proposée dans certaines études pour réaliser des transistors de même type à tensions de seuil distinctes est d'intégrer différents matériaux de grille pour ces transistors. Cependant, la réalisation pratique d'un tel circuit intégré s'avère techniquement délicate et économiquement prohibitive.

Il existe donc un besoin pour des circuits intégrés présentant des transistors à niveaux de seuil différents qui puissent être réalisés avec une complexité réduite. Le brevet US 6063886-A décrit l'influence sur la tension de seuil de l'association des types de dopages respectifs de la grille et du plan de masse.

L'invention vise à résoudre un ou plusieurs de ces inconvénients. L'invention porte ainsi sur un circuit intégré comprenant une couche active semi-conductrice séparée d'une couche substrat semi-conductrice par une couche de matériau isolant enterrée, comprenant des transistors PMOS et NMOS, le circuit comprenant :

- des premier et deuxième transistors d'un même type, PMOS ou NMOS ;
- des premier et deuxième plans de masse disposés à l'aplomb respectivement des premier et deuxième transistors entre la couche de matériau isolant enterrée et la couche substrat de silicium.

De plus :

- le premier transistor présente un type de dopage de son plan de masse opposé à celui de sa source, et présente une première tension de seuil ;
- le deuxième transistor présente un type de dopage de son plan de masse identique à celui de sa source, et présente une deuxième tension de seuil ;
- la première tension de seuil est fonction de la différence de potentiel appliquée entre la source et le plan de masse du premier transistor ;
- la deuxième tension de seuil est fonction de la différence de potentiel appliquée entre la source et le plan de masse du deuxième transistor ;
- les première et deuxième tensions de seuil pouvant varier respectivement dans une première et une deuxième plage de tensions dans le cas où la différence de potentiel entre le plan de masse et la source du premier ou deuxième transistor varie entre une valeur nulle et une valeur égale à la tension d'alimentation du circuit;
- l'épaisseur de la couche de matériau isolant est suffisamment fine pour que la valeur maximale de la première plage soit supérieure d'au moins 10% à la valeur minimale de la première plage, et la valeur minimale de la deuxième plage soit inférieure d'au moins 10% à la valeur maximale de la deuxième plage.

Selon une variante, la valeur maximale de la première plage est supérieure à la valeur maximale de la deuxième plage.

Selon une autre variante, la valeur maximale de la première plage est supérieure d'au moins 40mV à la valeur minimale de la première plage, et la valeur minimale de la deuxième plage est inférieure d'au moins 40mV à la valeur maximale de la deuxième plage.

Selon encore une variante, l'épaisseur de la couche de matériau isolant enterrée au niveau des premier et deuxième transistors est suffisamment fine de sorte que la première tension de seuil est supérieure à la deuxième tension de seuil lorsqu'une même différence de potentiel de référence est appliquée entre la source et le plan de masse des premier et deuxième transistors.

Selon encore une autre variante, les premier et deuxième transistors présentent des grilles respectives réalisées dans le même type de métal.

Selon une variante, les premier et deuxième transistors présentent une structure identique à l'exception du dopage de leur plan de masse.

Selon encore une variante, les premier et deuxième transistors présentent des grilles respectives réalisées dans des métaux respectifs présentant des travaux de sortie distincts.

Selon une autre variante, le circuit comprend une mémoire incluant :

- au moins une ligne de mot ;
- au moins deux lignes de bit ;
- une cellule mémoire de type 4T incluant des troisième et quatrième transistors et incluant également des cinquième et sixième transistors, le cinquième transistor présentant une structure similaire à celle du troisième transistor pour présenter une même tension de seuil, le sixième transistor présentant une structure similaire à celle du quatrième transistor pour présenter une même tension de seuil, les troisième et quatrième transistors étant de types opposés, les troisième et cinquième transistors étant connectés pour former une bascule bistable présentant deux noeuds de stockage, les quatrième et sixième transistors étant commandés par la ligne de mot pour connecter sélectivement les noeuds de la bascule bistable à des lignes de bit respectives.

Selon encore une autre variante, la différence de potentiel entre la source des troisième et cinquième transistors et leur plan de masse respectif est sensiblement nulle, et la différence de potentiel entre la source des quatrième et sixième transistors et leur plan de masse respectif est sensiblement égale à une tension Vdd.

Selon une variante, le circuit comprend une mémoire incluant :

- au moins une ligne de mot ;
- au moins deux lignes de bit ;
- une cellule mémoire de type 4T incluant des troisième et quatrième transistors et incluant également des cinquième et sixième transistors, les troisième à sixième transistors étant disposés à l'aplomb de plans de masse respectifs entre la couche de matériau isolant enterrée et la couche substrat de silicium, le cinquième transistor étant du même type que le troisième transistor, le sixième transistor étant du même type que le quatrième transistor, les troisième et quatrième transistors étant de types opposés, les troisième et cinquième transistors étant connectés pour former une bascule bistable présentant deux noeuds de stockage, les plans de masse des troisième et quatrième transistors étant connectés à la grille du troisième transistor et les plans de masse des cinquième et sixième transistors étant connectés à la grille du cinquième transistor, les quatrième et sixième transistors étant commandés par la ligne de mot pour connecter sélectivement les noeuds de la bascule bistable à des lignes de bit respectives.

Selon encore une variante, le circuit comprend une mémoire incluant des première et deuxième cellules mémoire de type 6T présentant chacune, une ligne de mot, deux lignes de bit, deux transistors de charge et deux transistors de conduction connectés pour former une bascule bistable présentant deux noeuds de stockage, chaque cellule mémoire comprenant en outre deux transistors d'accès commandés par la ligne de mot pour connecter sélectivement les noeuds de la bascule bistable aux lignes de bit respectives, le premier transistor formant un transistor d'accès de la première cellule mémoire et le deuxième transistor formant un transistor d'accès de la seconde cellule mémoire.

Selon encore une autre variante, les transistors de conduction des cellules mémoire présentent un type de dopage de leur plan de masse identique à celui du plan de masse de leur transistor d'accès, une épaisseur de la couche de matériau isolant identique à celle de leur transistor d'accès et une polarisation de leur plan de masse identique à celle du plan de masse de leur transistor d'accès.

Selon une variante, un plan de masse est commun pour un transistor de conduction et pour un transistor d'accès d'une des cellules mémoire.

Selon encore une variante, le circuit comprend des première et deuxième portes logiques, chaque porte logique comprenant au moins deux transistors commandés par des bornes d'entrée respectives, ledit premier transistor formant un desdits transistors de la première porte logique et ledit second transistor formant un desdits transistors de la deuxième porte logique.

Selon une variante, lesdits premier et deuxième transistors sont de type nMOS.

Selon encore une variante, la différence de potentiel entre le plan de masse du premier transistor et sa source est nulle, et la différence de potentiel entre le plan de masse du second transistor et sa source est égale à une tension Vdd.

Selon une autre variante, la couche de matériau isolant enterrée présente une épaisseur inférieure à 50nm et la largeur de la grille desdits transistors est inférieure à 50nm.

Selon encore une autre variante, la couche de matériau isolant enterrée présente une épaisseur inférieure à la longueur de grille d'un desdits transistors.

Selon une variante, le circuit comprend un septième transistor ménagé dans la couche active semi-conductrice, ce septième transistor étant dépourvu de plan de masse entre la couche de matériau isolant enterrée et la couche substrat de silicium à son aplomb.

Selon encore une variante, le circuit comprend un huitième transistor de type nMOS et un neuvième transistor de type pMOS,

- des huitième et neuvième plans de masse disposés à l'aplomb respectivement des huitième et neuvième transistors entre la couche de matériau isolant enterrée et la couche substrat de silicium, le huitième plan de masse présentant un dopage de type P et le neuvième plan de masse présentant un dopage de type N ;
- un caisson à dopage de type N séparant le huitième plan de masse de la couche substrat de silicium ;
- un caisson à dopage de type P séparant le neuvième plan de masse de la couche substrat de silicium ;
- une tranchée d'isolation s'étendant de la couche active de silicium jusqu'auxdits caissons de façon à séparer les huitième et neuvième plans de masse.

Selon encore une autre variante, le caisson à dopage de type N est excité par une tension Vdd, et le caisson à dopage de type P est connecté à une masse.

Selon une variante, le circuit comprend un module logique incluant le deuxième transistor, le premier transistor raccordant le module logique à une tension d'alimentation, une différence de potentiel nulle étant appliquée entre la source et le plan de masse du premier transistor, une différence de potentiel d'une valeur nulle étant appliquée entre la source et le plan de masse du deuxième transistor.

Selon encore une variante, les premier et deuxième transistors sont accolés, les plans de masse des premier et deuxième transistors sont séparés de la couche substrat semi-conductrice par un premier caisson formant une bande et présentant un dopage d'un premier type, le premier caisson étant alimenté par un premier niveau de tension, le circuit intégré comprenant en outre des dizième et onzième transistors d'un type opposé aux premier et deuxième transistors, les dizième et onzième transistors étant accolés et présentant des plans de masse dont les types de dopage sont opposés, les plans de masse des dizième et onzième transistors étant séparés de la couche substrat semi-conductrice par un deuxième caisson accolé au premier caisson et formant une bande, le deuxième caisson présentant un dopage d'un deuxième type opposé au premier type, le deuxième caisson étant alimenté par un deuxième niveau de tension, les premier et dizième transistors présentant des grilles respectives dont les travaux de sortie sont distincts, les deuxième et onzième transistors présentant des grilles respectives dont les travaux de sortie sont distincts.

Selon encore une autre variante, les premier et dizième transistors sont accolés et appartiennent à une même porte logique, et les deuxième et onzième transistors sont accolés et appartiennent à une même porte logique, et le type de dopage du plan de masse du premier transistor est opposé au type de dopage du plan de masse du dizième transistor, et les premier et deuxième transistors présentent des grilles respectives dont les travaux de sortie sont distincts.

D'autres caractéristiques et avantages de l'invention ressortiront clairement de la description qui en est faite ci-après, à titre indicatif et nullement limitatif, en référence aux dessins annexés, dans lesquels :

- la figure 1 est une représentation schématique d'une cellule mémoire ;
- la figure 2 est une vue en coupe d'un transistor réalisé sur un substrat SOI muni d'une couche isolante enterrée ;
- la figure 3 illustre la tension de seuil d'un transistor nMOS en fonction de différents paramètres ;
- la figure 4 est un tableau fournissant des niveaux de tension de seuil d'un transistor nMOS et d'un transistor pMOS en fonction de différents paramètres ;
- la figure 5 illustre le courant de conduction d'un transistor nMOS en fonction de différents paramètres ;
- la figure 6 illustre le courant de fuite d'un transistor nMOS en fonction de différents paramètres ;
- la figure 7 est un schéma électrique d'un exemple de cellule mémoire de type 4T selon l'invention ;
- la figure 8 est un diagramme représentant respectivement les courants de drain en fonction de la tension de grille (de IOFF à ION) d'un transistor de conduction et d'un transistor d'accès ;
- la figure 9 est un diagramme représentant la marge de stabilité d'une cellule mémoire en mode lecture et en mode rétention en fonction de l'épaisseur de la couche isolante ;
- la figure 10 est un diagramme représentant la marge de stabilité d'une cellule mémoire en mode lecture et en mode rétention en fonction du dopage du plan de masse ;
- la figure 11 est un diagramme représentant le courant de lecture de la cellule et le courant de fuite consommé en fonction de l'épaisseur de la couche isolante ;
- la figure 12 est un tableau illustrant les performances électriques respectives de deux types de cellules mémoire ;
- les figures 13 et 14 sont des topologies pour les deux types de cellules mémoire comparées dans le tableau de la figure 12 ;
- la figure 15 est une topologie d'une matrice de cellules mémoire ;
- la figure 16 est un diagramme représentant une plage de tension de polarisation d'une couche substrat ;
- la figure 17 est un schéma électrique d'une variante de cellule mémoire de type 4T ;
- la figure 18 est un schéma électrique d'un premier exemple de cellule mémoire de type 6T intégrée dans un circuit selon l'invention ;
- la figure 19 est une vue en perspective de la cellule mémoire de la figure 18 selon un exemple de topologie ;
- la figure 20 est une topologie d'une matrice de cellules mémoire selon la figure 18 ;
- la figure 21 est un schéma électrique d'un autre exemple de cellule mémoire de type 6T intégrée dans un circuit selon l'invention ;
- la figure 22 est une vue en perspective de la cellule mémoire de la figure 21 selon un exemple de topologie ;
- la figure 23 est une topologie d'une matrice de cellules mémoire selon la figure 21 ;
- la figure 24 est un schéma électrique d'un exemple de porte logique intégrée dans le substrat d'un circuit selon l'invention ;
- la figure 25 est une topologie de la porte logique de la figure 24 ;
- la figure 26 est un schéma électrique d'un autre exemple de porte logique intégrée dans le substrat d'un circuit selon l'invention ;
- la figure 27 est une topologie de la porte logique de la figure 26 ;
- la figure 28 est une représentation schématique d'un circuit intégré comprenant des portes logiques selon la figure 2 et des portes logiques selon la figure 26 ;
- la figure 29 est un schéma électrique de mémoire de type 4T à polarisation dynamique des plans de masse ;
- les figures 30 à 32 illustrent un exemple de circuit intégré comprenant des transistors à différentes tensions de seuil, en jouant sur les travaux de sortie de leur grille ;
- les figures 33 et 34 illustrent un exemple de circuit intégré incluant des transistors présentant des seuils de tension distincts ;.

- la figure 35 est une vue en coupe de deux transistors accolés à tension de seuil standard selon une alternative ;
- la figure 36 est un diagramme illustrant l'influence du travail de sortie de la grille sur la tension de seuil d'un transistor nMOS.

On se propose de réaliser l'invention sur un circuit intégré muni de transistors, un premier transistor pouvant avoir une première tension de seuil alors qu'un second transistor peut avoir une deuxième tension de seuil. Afin de moduler les tensions de seuil de ces transistors dans des plages de valeurs différentes, le premier transistor a un dopage de son plan de masse opposé à celui de sa source, alors que le deuxième transistor a un dopage de son plan de masse identique à celui de sa source. On utilise une épaisseur de couche isolante sous les transistors suffisamment faible pour que la première tension de seuil soit supérieure à la deuxième tension de seuil pour l'application d'une même différence de potentiel de référence.

Les tensions de seuil et les différences de potentiel entre une source et un plan de masse seront identifiées en valeur absolue dans ce qui suit.

La figure 2 représente un exemple de structure de transistor 1 réalisé en technologie SOI et muni d'un plan de masse. Le transistor 1 comprend une couche substrat de silicium 101. Le transistor 1 comprend une couche enterrée de matériau isolant 103 séparé de la couche substrat 101 par l'intermédiaire d'un plan de masse 102. La couche isolante 103 est surmontée par une couche active de silicium dans laquelle une source S, un canal 104 et un drain D sont ménagés. Le plan de masse 102 permet d'améliorer le contrôle électrostatique du transistor en limitant la pénétration des champs électriques générés par le drain et la source sous le canal 104. La réduction du couplage électrostatique latéral réduit les effets canaux courts et limite l'effet de déplétion par le drain DIBL. Le canal 104 est recouvert par une couche d'oxyde de grille 105. L'oxyde de grille 105 est surmonté par un empilement de grille comprenant une grille métallique 108 et une couche de polysilicium 111. L'empilement est délimité latéralement par des espaceurs 110. Des tranchées d'isolation 106 et 107 sont placées autour du transistor 1 entre la surface de la couche active de Silicium jusqu'en dessous de la partie inférieure du plan de masse 102 dans la couche de substrat 101.

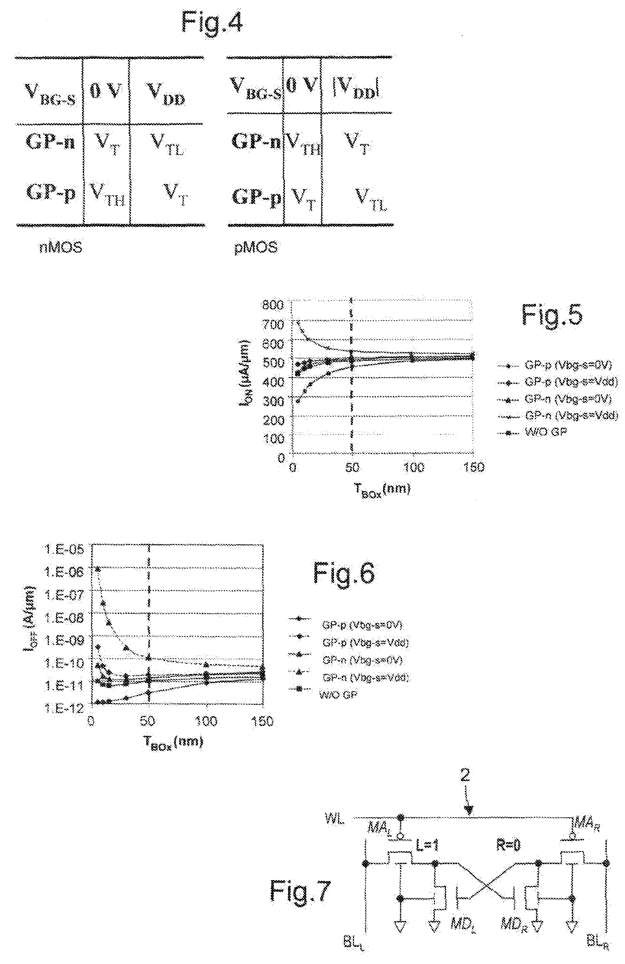

Les figures 3 et 4 illustrent des résultats de tests réalisés avec les paramètres de transistors présentant les caractéristiques suivantes :

$$V_{DD}=1V$$

L (longueur de grille effective)= 33nm de longueur de grille physique
$T_{Si}$ (épaisseur du canal)=8nm
$N_{GP}$ (dopage du plan de masse)=$10^{18}$cm$^{-3}$
$N_S$ (dopage de la couche substrat)=$3*10^{15}$cm$^{-3}$. La couche substrat 101 pourra présenter un même type de dopage que le plan de masse 102, avec un niveau de dopage très inférieur. La couche substrat 101 pourra présenter un dopage de type P.

Le potentiel de source est référencé à 0V
Le canal 104 est faiblement dopé (équivalent au dopage $N_S$ du substrat).
La figure 3 illustre la variation de la tension de seuil pour un transistor nMOS en fonction de différents paramètres. Pour référence, la figure 3 illustre également la tension de seuil d'un transistor nMos dépourvu de plan de masse (courbe référencée W/O GP). Les deux paramètres influençant la tension de seuil des transistors testés sont : l'épaisseur de la couche isolante (Tbox) et la polarisation du plan de masse par rapport à la source (Vbg-s désigne la tension entre le plan de masse et la source). Sur le diagramme de gauche, le dopage du plan de masse est opposé à celui du drain et de la source de son transistor (dopage P+ du plan de masse pour un transistor nMOS dont la source et le drain présentent un dopage N). Sur le diagramme de droite le dopage est identique (dopage N+ du plan de masse pour un transistor nMOS dont la source et le drain présentent un dopage N). Pour une épaisseur de couche isolante donnée, on constate que la tension de seuil du transistor à dopage opposé varie sur une première plage en fonction de la tension de polarisation, tandis que la tension de seuil du transistor à dopage identique varie sur une deuxième plage en fonction de la tension de polarisation. Pour une épaisseur de couche isolante 20nm, la première plage s'étend entre 430 et 600mV et la deuxième plage s'étend entre 200 et 460mV. La valeur supérieure de la première plage est supérieure à la valeur supérieure de la deuxième plage. Lorsqu'une même tension de référence est appliquée entre le plan de masse et la source des transistors à dopage identique et à dopage opposé, la tension de seuil du transistor à dopage opposé est supérieure à la tension de seuil du transistor à dopage identique.

On constate également que l'amplitude des première et deuxième plages s'accroît lorsqu'on diminue l'épaisseur de la couche isolante. Plus la couche isolante est fine, plus la valeur supérieure de la première plage augmente et plus la valeur inférieure de la deuxième plage baisse.

Pour une épaisseur donnée de la couche isolante et avec un type de dopage donné du plan de masse, la tension de seuil des transistors varie respectivement dans les première et deuxième plages. Une baisse de la différence de potentiel entre le plan de masse et la source induit une hausse de la tension de seuil des transistors.

Avec une couche isolante fine, un dopage opposé (dopage P+ du plan de masse pour un transistor nMOS) et une différence de tension réduite entre le plan de masse et la source, la tension de seuil du transistor est sensiblement augmentée par rapport au transistor de référence sans plan de masse. Une telle tension de seuil relevée sera désignée par la suite par Vth. Avec une couche isolante fine, un dopage identique (dopage N+ du plan de masse pour un transistor nMOS) et une différence de tension de Vdd entre le plan de masse et la source, la tension de seuil du transistor est sensiblement diminuée par rapport au transistor de référence sans plan de masse.

Dans les autres cas (dopage identique avec Vbg-s=0 ou dopage opposé avec Vbg-s=Vdd), la tension de seuil est modifiée dans une moindre mesure par rapport au transistor de référence sans plan de masse, même avec une épaisseur de la couche isolante très faible. La tension de seuil du transistor de référence servira de tension de référence et sera désignée par le terme tension de seuil standard Vt. Dans l'exemple illustré à la figure 3, la tension standard Vt du transistor nMOS est comprise entre 460 et 480mV en fonction de l'épaisseur de la couche isolante.

Une augmentation de la différence de potentiel entre le plan de masse et la source d'un transistor à tension de seuil Vth rapproche la tension de seuil de ce transistor de la tension de seuil standard Vt. Un changement de type de dopage du plan de masse d'un transistor à tension de seuil Vth conduit à un transistor à tension de seuil standard Vt.

Bien que la figure 3 illustre le fonctionnement de transistors nMos, des résultats similaires sont obtenus. Les tensions Vth, Vtl et Vts des nMos et pMos pourront être légèrement différentes pour une même épaisseur de couche isolante.

On pourra par exemple considérer qu'une tension de seuil est de type Vth ou Vtl si elle diffère d'au moins 5% par rapport à la tension de seuil standard Vts, de préférence d'au moins 10%, voire d'au moins 20%. On pourra également considérer qu'une tension de seuil est de type Vth ou Vtl si elle diffère d'au moins 30mV par rapport à la tension de seuil standard Vts, de préférence d'au moins 40mV, voire d'au moins 60mV.

La figure 4 synthétise les variations de tensions de seuil obtenues pour une couche isolante fine en fonction de la polarisation et du dopage du plan de masse respectivement pour un transistor nMOS et pour un transistor pMOS. Vth correspond à une tension de seuil relevée, Vtl correspond à une tension de seuil rabaissée et Vt correspond à une tension de seuil standard. Gp-n désigne un plan de masse dont le dopage est de type n, Gp-p désigne un plan de masse dont le dopage est de type p.

Pour obtenir un transistor nMOS à tension de seuil rabaissée Vtl, on applique une différence de potentiel Vdd entre le plan de masse présentant un dopage de type n et la source. Pour obtenir un transistor nMOS à tension de seuil relevée Vth, on applique la polarisation de la source sur un plan de masse présentant un dopage de type p. Pour obtenir un transistor pMOS à tension de seuil relevée Vth, on applique la polarisation de la source sur un plan de masse présentant un dopage de type n. Pour obtenir un transistor pMOS à tension de seuil rabaissée Vtl, on applique une différence de potentiel Vdd entre le plan de masse présentant un dopage de type p et la source.

La figure 5 illustre l'évolution du courant de conduction d'un transistor nMOS en fonction des différents paramètres. Trois paramètres influencent le courant de conduction des transistors testés : l'épaisseur de la couche isolante, la polarisation du plan de masse et le dopage du plan de masse. Le courant de conduction d'un transistor de référence sans plan de masse est également illustré. Un dopage du plan de masse opposé à celui du drain et de la source permet de réduire le courant de conduction, tandis qu'un dopage identique à celui du drain et de la source permet d'accroître le courant de conduction. Plus la différence de potentiel entre le plan de masse et la source est importante, plus le courant de conduction est important. La variation des paramètres testés permet ainsi d'obtenir une augmentation du courant de conduction atteignant 200 $\mu$A/$\mu$m pour une couche isolante 20nm d'épaisseur. La variation des paramètres testés permet également d'obtenir une diminution du courant de conduction atteignant 130$\mu$A/$\mu$m pour une couche isolante 20nm d'épaisseur. Des résultats similaires sont obtenus avec un transistor pMOS.

La figure 6 illustre l'évolution du courant de fuite en fonction des différents paramètres pour un transistor nMOS. Trois paramètres influencent le courant de fuite des transistors testés : l'épaisseur de la couche isolante, la polarisation du plan de masse et le dopage du plan de masse. Le courant de fuite d'un transistor de référence sans plan de masse est également illustré. Un dopage du plan de masse opposé à celui de la source associé à une différence de potentiel entre le plan de masse et la source réduite (transistor à seuil Vth) permet de réduire le courant de fuite par rapport au transistor de référence. Un dopage du plan de masse identique à celui de la source associé à une différence de potentiel Vdd entre le plan de masse et la source (transistor à seuil Vtl) accroît le courant de fuite par rapport au transistor de référence. Pour une couche isolante inférieure à 50nm, la variation des paramètres testés permet ainsi d'obtenir une modulation comprise entre 2 et 6 décades du courant de fuite entre un transistor à seuil Vth et un transistor à seuil Vtl.

Les lignes en traits discontinus sur les figures 3, 5 et 6 représentent la limite entre ce qui sera considéré comme une couche isolante fine et une couche isolante épaisse. Pour les dimensions des transistors mis en oeuvre dans ces simulations, cette limite est approximativement de 50 nm. On constate en effet que des variations de tensions de seuil ou de courants de conduction deviennent significatives par rapport au transistor de référence sans plan de masse lorsque l'épaisseur de la couche isolante est inférieure à 50 nm.

Avec L la longueur de grille du transistor, l'épaisseur Tbox de la couche isolante sera ainsi avantageusement choisie selon la règle suivante : Tbox<L. On disposera ainsi d'une règle empirique pour déterminer une épaisseur d'isolant fine en fonction de la taille des dimensions du transistor.

Bien que les tests aient étés réalisés avec un plan de masse présentant un dopage $20^{18}cm^{-3}$, un dopage compris entre $2*10^{17}cm^{-3}$ et $5*10^{18}cm^{-3}$ pourra être utilisé.

Bien que les diagrammes des figures 3, 5 et 6 aient été réalisés pour un transistor nMOS, on obtient des conclusions similaires pour un transistor pMOS. Du fait de la logique inverse des transistors pMOS, avec une couche isolante fine, on obtient une augmentation de la valeur absolue de la tension de seuil pour un dopage du plan de masse opposé à celui de la source, et avec une différence de potentiel réduite entre la source et le plan de masse. Les courants de fuite et de conduction du transistor pMOS sont alors réduits. Avec une couche isolante fine, on obtient une diminution de la valeur absolue de la tension de seuil du transistor pMOS avec un type de dopage identique entre la source et le plan de masse, et avec une différence de potentiel relevée entre la source et le plan de masse. Les courants de fuite et de conduction du transistor pMOS sont alors relevés.

L'utilisation de ces propriétés de modulation des paramètres des transistors s'avère particulièrement avantageuse dans un circuit intégré selon l'invention.

La figure 7 représente le schéma électrique d'une cellule mémoire 2 de type 4T selon l'invention. Deux transistors de conduction $MD_L$ et $MD_R$ de type nMOS sont connectés de façon à former une bascule bistable, de façon connue en soi. Les transistors de conduction $MD_L$ et $MD_R$ sont réalisés dans des couches actives de Silicium. Les couches actives de Silicium surmontent une couche isolante placée au-dessus d'un plan de masse. Le plan de masse des transistors de conduction est connecté à la masse. La cellule mémoire 2 comprend deux transistors d'accès $MA_L$ et $MA_R$ de type pMOS. Les transistors d'accès $MA_L$ et $MA_R$ sont réalisés dans des couches actives de Silicium. Les couches actives de Silicium surmontent une couche isolante réalisée au-dessus d'un plan de masse. Le plan de masse des transistors d'accès est connecté à la masse. La source des transistors d'accès $MA_L$ et $MA_R$ est connectée respectivement aux lignes de bit $BL_L$ et $BL_R$ respectivement. La grille des transistors d'accès $MA_L$ et $MA_R$ est connectée à une ligne de mot WL. La source des transistors de conduction $MD_L$ et $MD_R$ est connectée à la masse. Le drain des transistors de conduction $MD_L$ et $MD_R$ est connecté au drain respectif des transistors d'accès $MA_L$ et $MA_R$.

La fonction des transistors de conduction $MD_L$ et $MD_R$ est de maintenir le noeud de stockage de niveau logique 0 proche du potentiel de masse en rétention. La fonction des transistors d'accès $MA_L$ et $MA_R$ est de maintenir le noeud de stockage de niveau logique 1 proche du potentiel Vdd en rétention et de permettre l'accès aux potentiels des noeuds de stockage lors des cycles de lecture et d'écriture.

Les plans de masse ménagés sous les transistors $MD_L$ et $MD_R$ et $MA_L$ et $MA_R$ sont connectés à la masse. Une différence de potentiel de Vdd est appliquée entre la source et le plan de masse des transistors d'accès $MA_L$ et $MA_R$, comme cela ressortira par la suite. Une différence de potentiel nulle est appliquée entre la source et le plan de masse des transistors de conduction $MD_L$ et $MD_R$. Le dopage (P+) du plan de masse des transistors d'accès $MA_L$ et $MA_R$ (pMOS) est identique au dopage de leur source. Le dopage (P+) du plan de masse des transistors de conduction $MD_L$ et $MD_R$ (nMOS) est opposé au dopage de leur source. La cellule mémoire est avantageusement réalisée avec des transistors d'accès de type pMOS et des transistors de conduction de type nMOS, car les wafers sont habituellement fournis avec un dopage de type P par défaut, ce qui facilite la formation d'un plan de masse avec un dopage P+ approprié pour la modulation des tensions de seuil de ces transistors. La couche isolante sur laquelle les transistors $MD_L$ et $MD_R$ et $MA_L$ et $MA_R$ sont réalisés est fine au sens de l'invention, c'est-à-dire que son épaisseur permet de faire varier les tensions de seuil des transistors $MD_L$ et $MD_R$ et $MA_L$ et $MA_R$ avec les dopages et les polarisations appliqués sur leur plan de masse. Les transistors de conduction $MD_L$ et $MD_R$ présentent ainsi une tension de seuil relevée Vth. Les transistors d'accès $MA_L$ et $MA_R$ présentent ainsi une tension de seuil rabaissée Vtl.

Les transistors d'accès $MA_L$ et $MA_R$ peuvent utiliser un plan de masse commun puisque celui-ci peut présenter le même type de dopage et la même polarisation. De même, les transistors de conduction $MD_L$ et $MD_R$ peuvent utiliser un plan de masse commun puisque celui-ci peut présenter le même type de dopage et la même polarisation. Le plan de masse peut même être commun aux transistors d'accès et aux transistors de conduction puisqu'il présente la même polarisation et le même type de dopage pour tous ces transistors.

En mode rétention des données, les lignes de bit $BL_L$ et $BL_R$ et la ligne de mot WL sont polarisées au potentiel d'alimentation Vdd. Les transistors d'accès $MA_L$ et $MA_R$ sont alors à l'état bloqué. Dans l'exemple illustré, le transistor de conduction $MD_L$ est également dans un état bloqué contrairement au transistor $MD_R$.

La condition pour garder le potentiel du noeud L proche de Vdd et ainsi conserver le niveau logique 1 est que le courant de fuite traversant le transistor d'accès $MA_L$ ($I_{mal-off}$) soit supérieur d'au moins 2 à 3 décades à la somme du courant de fuite traversant le transistor de conduction $MD_L$ ($I_{mdl-off}$) et de celui tiré par la grille du transistor $MD_R$ ($I_{mdr-g}$) :

$$I_{MAL-OFF} \gg I_{MDL-OFF} + I_{MDR-G}$$

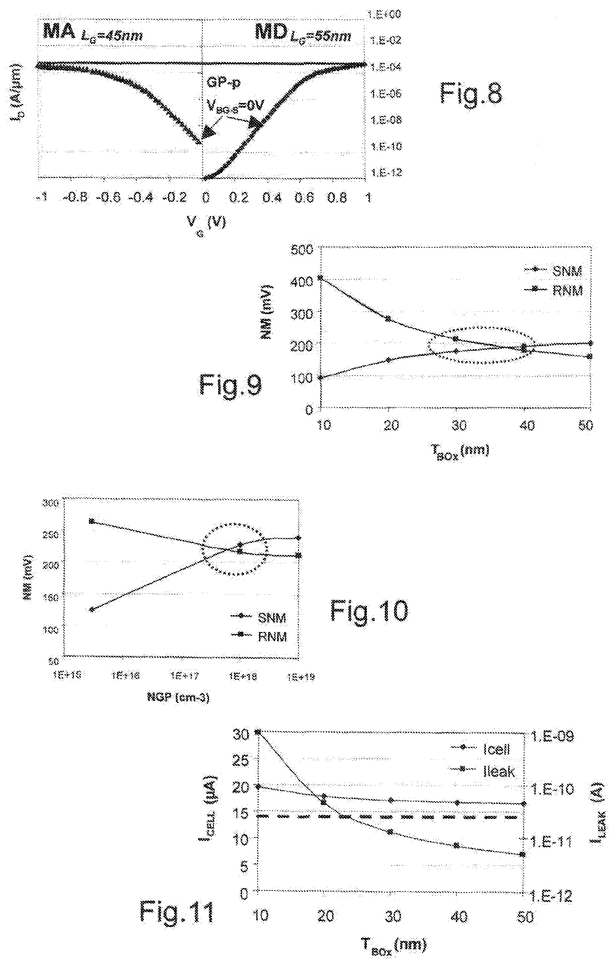

La cellule mémoire 2 proposée permet de satisfaire cette condition : les transistors d'accès $MA_L$ et $MA_R$ présentent une tension de seuil rabaissée Vtl (cf figure 4) qui permet d'accroître leur courant de fuite, alors que les transistors de conduction $MD_L$ et $MD_R$ présentent une tension de seuil relevée Vth (cf figure 4) qui permet de réduire leur courant de fuite (cf figure 5). Le respect de la condition de maintien du potentiel d'un noeud au niveau Vdd en mode rétention est ainsi facilité. La figure 8 (courant de drain en fonction de la tension de grille) montre notamment qu'avec des longueurs de grille Lg appropriées pour les transistors de conduction $MD_L$ et $MD_R$ et les transistors d'accès $MA_L$ et $MA_R$ (respectivement 55nm et 45nm), la condition sur les courants de fuite est aisément respectée puisqu'on obtient un écart entre les courants de conduction des transistors d'accès et des transistors de conduction de 2,5 décades.

Il n'est alors pas nécessaire de prévoir des circuits additionnels de rafraîchissement des données dans les noeuds de stockage de la cellule mémoire 2. Le contrôle de la tension de seuil des différents transistors peut être réalisé simplement sur l'ensemble des cellules par la structure de ces cellules et par la polarisation appropriée des plans de masse. La complexité du circuit intégrant la cellule mémoire 2 peut ainsi être réduite et sa densité peut être accrue. Il est également possible d'éviter l'utilisation de circuits modifiant dynamiquement la tension de seuil des transistors des cellules, qui nécessiteraient la présence de contacts de substrat au niveau de la cellule. La complexité du circuit intégrant la cellule mémoire 2 peut ainsi être réduite et sa densité peut être accrue.

En mode lecture, les lignes de bit $BL_L$ et $BL_R$ sont préalablement chargées à Vdd, puis la ligne de mot est polarisée à Vss (ou à un potentiel supérieur) pour rendre conducteurs les transistors $MA_L$ et $MA_R$ et ainsi permettre l'accès aux noeuds de stockage de la cellule mémoire 2.

La stabilité de la cellule mémoire 2 dans le mode lecture dépend de la relation entre les courants de conduction des transistors de conduction et d'accès connectés au noeud de stockage de niveau logique 0. Dans l'exemple de la figure 7, la condition pour garder le potentiel du noeud R proche de Vss (niveau logique 0) est que le courant de conduction qui traverse le transistor d'accès $MA_R$ ($I_{mar-on}$) soit inférieur (d'au moins un facteur 2 à 3) au courant de conduction du transistor $MD_R$ ($I_{mdr-on}$):

$$I_{MAR-ON} < I_{MDR-ON}$$

La condition de stabilité du noeud au niveau logique 0 en mode lecture est obtenue par un dimensionnement de la largeur (Wd) de grille des transistors de conduction supérieur à celui des transistors d'accès.

Pour optimiser la stabilité en rétention d'une cellule mémoire de type 4T, il est usuel d'augmenter la conductance des transistors pMOS et de diminuer la conductance des transistors nMOS. Cette optimisation va à l'encontre de l'optimisation de la stabilité en lecture, ce qui implique un compromis de dimensionnement. Comme les transistors pMOS sont intrinsèquement moins conducteurs que les transistors nMOS, et que la modulation des courants de conduction des transistors est moins élevée que la modulation des courants de fuite avec les paramètres des transistors selon l'invention, la stabilité en lecture de la cellule mémoire 2 peut être optimisée par un dimensionnement approprié des transistors. La stabilité en lecture peut également être optimisée en appliquant une tension supérieure à Vss sur la ligne de mot lors d'un accès en lecture à la cellule mémoire 2. Les transistors d'accès de type pMOS sont alors rendus moins conducteurs pour faciliter le respect de la condition de stabilité en lecture.

Le compromis de stabilité en rétention et en lecture de la cellule mémoire 2 peut être optimisé en fonction de l'épaisseur de la couche isolante et du dopage du plan de masse, comme cela ressort des diagrammes des figures 9 et 10. Ces diagrammes délimitent une zone d'optimisation dans la partie en pointillés, à la fois pour l'épaisseur Tbox de la couche isolante (figure 9) et pour le dopage $N_{GP}$ du plan de masse (figure 10), pour les paramètres de transistors suivants :

$$V_{DD}=1V$$

L (largeur de grille)=45nm
$T_{Si}$ (épaisseur du canal)=8nm
$N_{GP}$ (dopage du plan de masse)=$10^{18}$cm$^{-3}$
$N_S$ (dopage de la couche substrat)=$3*10^{15}$cm$^{-3}$

Le potentiel de source est référencé à 0V

Les courbes SNM correspondent à la stabilité en lecture, tandis que les courbes RNM correspondent à la stabilité en rétention.

En mode écriture, une différence de potentiel est appliquée entre les lignes de bit $BL_L$ et $BL_R$. La ligne de mot est ensuite polarisée à Vss pour rendre conducteurs les transistors d'accès $MA_L$ et $MA_R$. En fonction de la différence de potentiel appliquée entre les lignes de bit $BL_L$ et $BL_R$, la cellule commute : si la ligne de bit $BL_L$ est à l'état logique 0 et si la ligne de bit $BL_R$ est à l'état 1, alors le noeud L passe à 0 et le noeud R passe à 1.

Bien que les tests effectués correspondent à une technologie FDSOI, des résultats similaires peuvent également être obtenus avec des technologies dites 'Localized FDSOI' et 'Silicon on Nothing'.

Le diagramme de la figure 11 illustre la variation du courant consommé par la cellule en rétention ($I_{leak}$) et du courant de cellule ($I_{cell}$) en fonction de l'épaisseur Tbox de la couche isolante selon une simulation. La ligne en traits discontinus illustre une limite de courant de fuite maximum qui peut être choisie pour déterminer le dimensionnement des transistors. Une épaisseur de la couche isolante de 30 nm s'avère appropriée. L'épaisseur de la couche isolante pourra bien entendu être adaptée en fonction de la dimension des transistors. Ainsi, on peut envisager d'adapter l'épaisseur Tbox de la couche isolante approximativement de la façon suivante : Tbox<L.

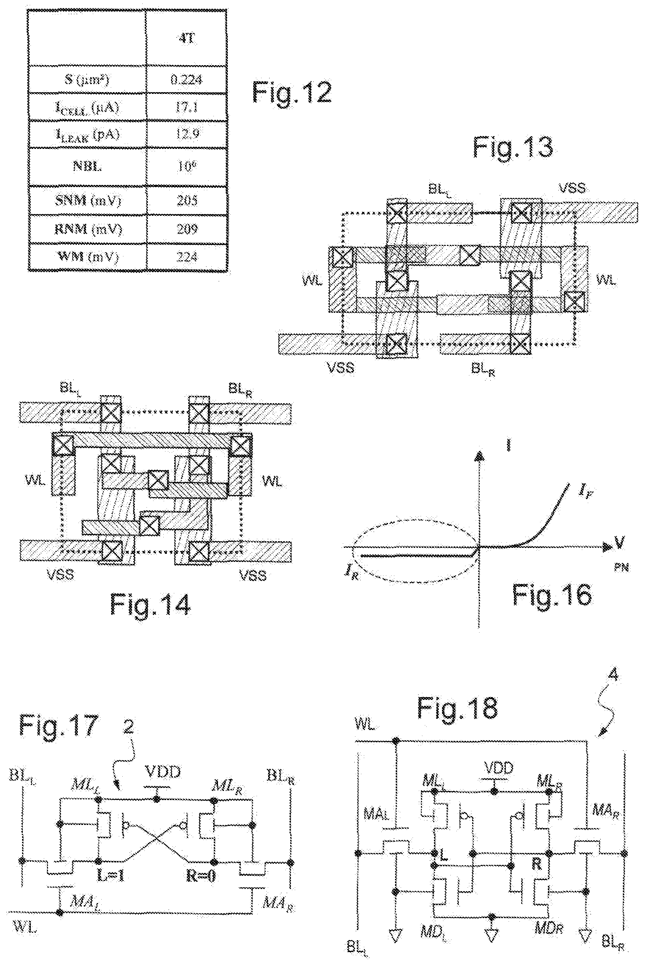

A partir de ces données de dimensionnement, la topologie de la cellule mémoire, illustrée par la figure 13, a été dessinée. La figure 14 donne un deuxième exemple de dessin de la même cellule. Dans cet exemple, la topologie vise à garantir que la stabilité en lecture et en rétention de la cellule mémoire atteigne au moins 20% de la tension Vdd (soit 200mV avec Vdd=1V). La cellule a été conçue pour des applications à faible consommation de courant (environ 10 pA par cellule). Des simulations ont permis de déterminer qu'une largeur des transistors de conduction (Wd) d'au moins 115nm s'avérait satisfaisant pour garantir que la stabilité en lecture et en rétention atteigne le seuil des 20% de la tension $V_{DD}$. On a utilisé les règles de dimensionnement pour des mémoires SRAM en 45nm telles que définies dans le document de M Boeuf intitulé « *0.248$\mu m^2$ and 0.334$\mu m^2$ Conventional Bulk 6T-SRAM bit -cells for 45nm node Low Cost - General Purpose Applications»* et publié dans Symposium on VLSI Technology Digest of Technical Papers, 2005. On a ainsi utilisé les paramètres de dimensionnement suivants : Wd=115nm, Ld=55nm (longueur de grille du transistor de conduction), Wa=55nm (largeur de grille du transistor d'accès) et La=45nm (longueur de grille du transistor d'accès).

Le tableau de la figure 12 illustre les résultats électriques obtenus. On note un excellent compromis entre la stabilité en lecture et en rétention. La marge d'écriture (WM), définie par la différence de potentiel nécessaire entre les lignes de bit lors d'une écriture, s'avère très basse ce qui garantit une excellente capacité d'écriture dans la cellule. La surface S occupée par la cellule est également très réduite.

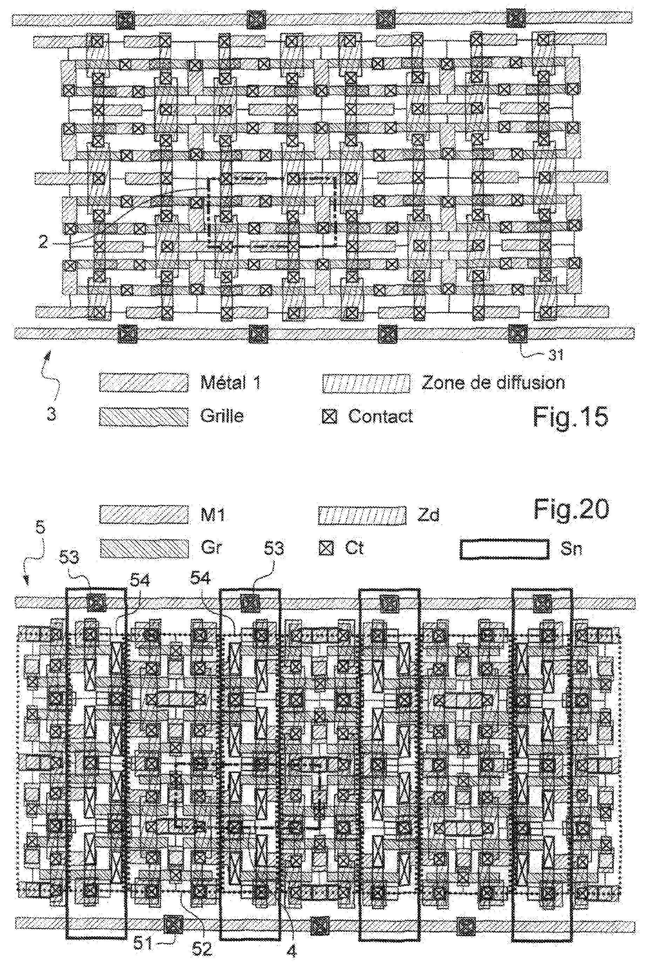

Les plans de masse des transistors peuvent être connectés ensemble par la couche substrat de Silicium. La figure 15 illustre la topologie d'une matrice 31 de 4 par 4 cellules mémoire 2. La couche substrat est connectée à la masse par des prises de substrat 31. On peut cependant également envisager de connecter la couche substrat à la masse par l'intermédiaire de sa face arrière.

On peut envisager de polariser la couche substrat de la cellule par le biais de sources de tension externes, afin de moduler la tension de seuil des transistors. La figure 16 illustre une gamme de tensions à respecter dans la zone en traits discontinus. Par exemple, si la couche substrat de type P est polarisée à 0V, le caisson de type N devra avoir une tension de polarisation comprise entre 0V et Vdd. On évite ainsi de polariser en direct la jonction PN qui pourrait générer un important courant direct à l'origine de fuites de la cellule mémoire 2.

La figure 17 est un schéma électrique d'une variante de cellule mémoire 2 de type 4T réalisée en logique inverse. Dans cet exemple, la cellule mémoire 2 comprend des transistors de charge $ML_L$ et $ML_R$ de type pMOS formant les noeuds de stockage et des transistors d'accès $MA_L$ et $MA_R$ de type nMOS. Les transistors d'accès $MA_L$ et $MA_R$ sont formés sur une couche isolante mince surmontant un plan de masse présentant une différence de potentiel Vdd avec leur source et présentant un dopage N+ (dopage identique à celui de la source). Les transistors de charge $ML_L$ et $ML_R$ sont formés sur une couche isolante mince surmontant un plan de masse présentant une différence de potentiel nulle avec leur source et présentant un dopage N+ (dopage opposé à celui de la source). Les transistors d'accès $MA_L$ et $MA_R$ présentent ainsi une tension de seuil rabaissée Vtl alors que les transistors de charge $ML_L$ et $ML_R$ présentent une tension de seuil relevée Vth (cf figure 4). Les conditions de stabilité en lecture et en rétention sont donc ainsi plus aisément satisfaites avec cette cellule mémoire 2 en logique inverse.

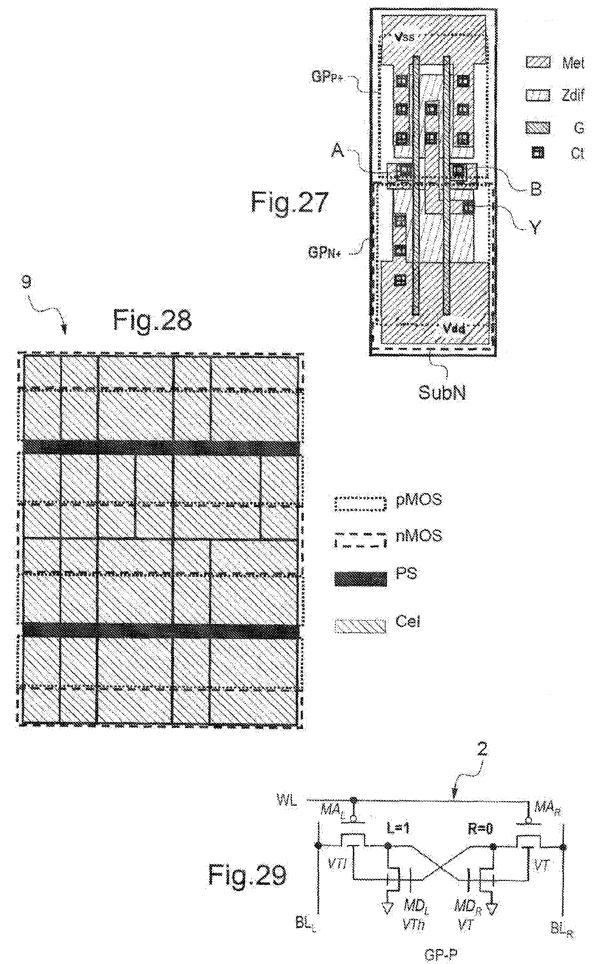

La figure 29 représente le schéma électrique d'une cellule mémoire 10 de type 4T dans lequel les plans de masse présentent une polarisation dynamique. Deux transistors de conduction $MD_L$ et $MD_R$ de type nMOS sont connectés de façon à former la bascule bistable avec deux noeuds de stockage R et L. Les transistors de conduction $MD_L$ et $MD_R$ surmontent une couche isolante réalisée au-dessus d'un plan de masse à dopage P+. La cellule mémoire 10 comprend deux transistors d'accès $MA_L$ et $MA_R$ de type pMOS. Les transistors d'accès $MA_L$ et $MA_R$ surmontent une couche isolante réalisée au-dessus d'un plan de masse à dopage P+. Les plans de masse des transistors $MD_L$ et $MA_L$ sont connectés au potentiel de grille du transistor $MD_L$. Les plans de masse des transistors $MD_R$ et $MA_R$ sont connectés au potentiel de grille du transistor $MD_R$. Dans l'exemple illustré, le noeud de stockage L mémorise une valeur 2, alors que le noeud de stockage R mémorise une valeur de 0. Le potentiel appliqué sur le plan de masse des transistors $MD_L$ et $MA_L$ est donc à la masse. La tension de seuil du transistor $MD_L$ est donc à Vth alors que la tension de seuil du transistor $MA_L$ est à Vtl (cf Fig. 4). Le potentiel appliqué sur le plan de masse des transistors $MD_R$ et $MA_R$ est donc à Vdd. La tension de seuil du transistor $MD_L$ est donc à Vt et la tension de seuil du transistor $MA_L$ est également à Vt (cf Fig. 4). Ainsi, on garantit d'une part la stabilité en rétention du noeud L à 1 avec des courants de fuite respectifs appropriés pour $MD_L$ et $MA_L$, et d'autre part une consommation réduite pour le transistor $MA_R$ qui présente une tension de seuil supérieure à celle du transistor $MA_L$ : cette tension de seuil supérieure n'est pas préjudiciable au fonctionnement de la cellule 10 puisque la rétention du noeud R à 0 n'impose pas la même condition sur les courants de fuite.

Les principales étapes d'un exemple de procédé de fabrication d'un circuit intégré de type FDSOI incluant de telles cellules mémoire pourront être les suivantes : en partant d'un wafer de type SOI, une couche d'isolant dépassant 140nm d'épaisseur peut être affinée par oxydation thermique et gravure humide. Des tranchées d'isolation sont ensuite formées. Des plans de charge aux dopages appropriés sont ensuite implantés sous les transistors nMOS et pMOS. Un diélectrique à constante diélectrique élevée tel que du $HfZrO_2$ est déposé avec une épaisseur d'approximativement 2.5nm. Une grille métallique (par exemple en ALD TiN d'une épaisseur 20nm) et une couche de polysilicium de 80 nm sont déposées pour former l'empilement de grille. Une lithographie à 193nm combinée à un rognage permet d'obtenir les dimensions de grille désirées. Des espaceurs de décalage 20nm sont réalisée, puis on effectue une épitaxie sélective 20nm dans des régions d'extension afin de réduire la résistance d'accès. Des extensions surélevées subissent une implantation. On réalise ensuite un espaceur de type Dshape, on réalise l'implatation de la source et du drain (activées par un procédé de type 'RTP spikes anneal' à 1080°C) puis une étape de siliciuration (NiPtSi). Des couches de nitride peuvent être ajoutées pour améliorer les performances.

L'invention trouve également une application dans les cellules mémoire de type 6T, théoriquement plus rapides et présentant une moindre densité d'intégration que des cellules de mémoire de type 4T. Les cellules mémoire de type 6T sont également théoriquement plus stables en modes rétention et présentent une marge en écriture plus réduite.

La figure 18 est un schéma électrique d'une cellule mémoire 4 de type 6T d'un circuit intégré selon l'invention. La cellule mémoire 4 de la figure 18 est destinée à optimiser la consommation électrique. De façon connue en soi, la cellule mémoire 4 comprend deux transistors d'accès $MA_L$ et $MA_R$ de type nMOS, deux transistors de conduction $MD_L$ et $MD_R$ de type nMOS et deux transistors de charge $ML_L$ et $ML_R$ de type pMOS. Les transistors de conduction $MD_L$ et $MD_R$ et les transistors de charge $ML_L$ et $ML_R$ sont connectés de façon connue en soi pour former une bascule bistable présentant des noeuds de stockage L et R. Les noeuds de stockage L et R sont sélectivement raccordés à la tension Vdd respectivement par l'intermédiaire des transistors de charge $ML_L$ et $ML_R$. Les noeuds de stockage L et R sont sélectivement raccordés à la masse respectivement par l'intermédiaire des transistors de conduction $MD_L$ et $MD_R$. Les noeuds de stockage L et R sont sélectivement raccordés aux lignes de bit $BL_L$ et $BL_R$ respectivement par l'intermédiaire des transistors d'accès $MA_L$ et $MA_R$. La grille des transistors d'accès $MA_L$ et $MA_R$ est connectée à une ligne de mot WL. La grille du transistor de charge $ML_L$ et la grille du transistor de conduction $MD_L$ sont connectées au noeud de stockage R. La grille du transistor de charge $ML_R$ et la grille du transistor de conduction $MD_R$ sont connectées au noeud de stockage L. L'utilisation des transistors d'accès $MA_L$ et $MA_R$ de type nMOS permet théoriquement un accès aux noeuds de stockage de la cellule mémoire 4 plus rapide qu'avec une cellule mémoire selon la figure 7.

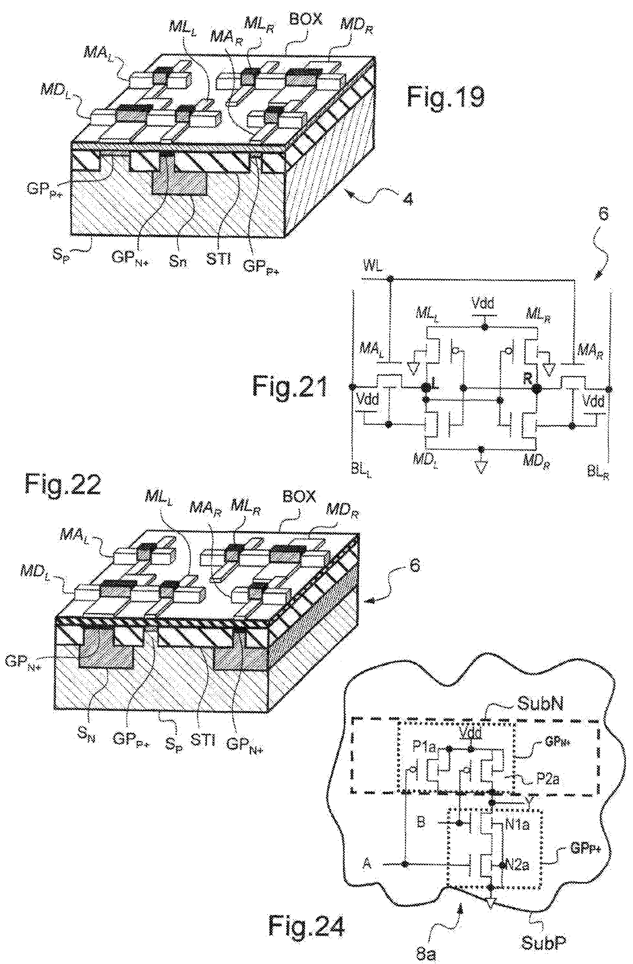

Comme illustré dans la topologie en coupe de la figure 19, les transistors nMOS $MA_L$ et $MD_L$ sont réalisés sur une couche isolante BOX et surplombent un plan de masse $GP_{P+}$. Les transistors nMOS $MA_R$ et $MD_R$ sont réalisés sur une couche isolante BOX fine surplombant un autre plan de masse $GP_{P+}$. Le dopage des plans de masse $GP_{P+}$ est opposé à celui de la source des transistors nMOS. Les plans de masse $GP_{P+}$ sont connectés au potentiel de masse. La différence de potentiel entre ces plans de masse et la source de leurs transistors nMOS est donc nulle. Par conséquent, on obtient une tension de seuil relevée Vth pour les transistors nMOS (cf Tableau de la figure 4).

Les transistors de charge $ML_L$ et $ML_R$ de type pMOS sont réalisés sur la couche isolante BOX et surplombent un plan de masse $GP_{N+}$. Le dopage des plans de masse $GP_{N+}$ est opposé à celui de la source des transistors pMOS $ML_L$ et $ML_R$. Une différence de potentiel nulle entre le plan de masse $GP_{N+}$ et la source des transistors $ML_L$ et $ML_R$ est appliquée. Par conséquent, on obtient une tension de seuil relevée Vth pour les transistors pMOS (cf Tableau de la figure 4).

La figure 20 est une topologie d'une matrice 5 de 4 par 4 cellules mémoire 4. Les références 52 désignent les plans de masse de type P+. Les plans de masse 52 sont polarisés par l'intermédiaire des points de contact 51. Les références 54 désignent les plans de masse de type N+. Les plans de masse 54 sont polarisés par l'intermédiaire des points de contact 53. Dans la légende, les zones identifiées par M1 correspondent aux zones de métallisation. Les zones identifiées par Gr correspondent à des grilles. Les zones identifiées par Zd correspondent à des zones de diffusion. Les zones identifiées par Sn correspondent à des implantations de caissons de substrat de type N. Pour gagner en densité d'intégration, la connexion électrique des couches substrat de type N et P est réalisée à la périphérie de la matrice, à l'extérieur des cellules mémoire 6. Afin de simplifier la réalisation des cellules mémoire 4, les transistors de charge $ML_L$ et $ML_R$ surplombent un même plan de masse $GP_{N+}$.

La figure 21 est un schéma électrique d'une cellule mémoire 6 de type 6T d'un circuit intégré selon l'invention. La cellule mémoire 6 de la figure 22 est destinée à optimiser le temps d'accès aux noeuds de stockage L et R. De façon connue en soi, la cellule mémoire 6 comprend deux transistors d'accès $MA_L$ et $MA_R$ de type nMOS, deux transistors de conduction $MD_L$ et $MD_R$ de type nMOS et deux transistors de charge $ML_L$ et $ML_R$ de type pMOS. Les transistors de conduction $MD_L$ et $MD_R$ et les transistors de charge $ML_L$ et $ML_R$ sont connectés pour former une bascule bistable présentant des noeuds de stockage L et R. Les noeuds de stockage L et R sont sélectivement raccordés à la tension Vdd respectivement par l'intermédiaire des transistors de charge $ML_L$ et $ML_R$. Les noeuds de stockage L et R sont sélectivement raccordés à la masse respectivement par l'intermédiaire des transistors de conduction $MD_L$ et $MD_R$. Les noeuds de stockage L et R sont sélectivement raccordés aux lignes de bit $BL_L$ et $BL_R$ respectivement par l'intermédiaire des transistors d'accès $MA_L$ et $MA_R$. La grille des transistors d'accès $MA_L$ et $MA_R$ est connectée à une ligne de mot WL. La grille du transistor de charge $ML_L$ et la grille du transistor de conduction $MD_L$ sont connectées au noeud de stockage R. La grille du transistor de charge $ML_R$ et la grille du transistor de conduction $MD_R$ sont connectées au noeud de stockage L. L'utilisation des transistors d'accès $MA_L$ et $MA_R$ de type nMOS permet théoriquement un accès aux noeuds de stockage de la cellule mémoire 6 plus rapide qu'avec une cellule mémoire selon la figure 7.

Comme illustré dans la topologie en coupe de la figure 22, les transistors nMOS $MA_L$ et $MD_L$ sont réalisés sur une couche isolante BOX et surplombent un plan de masse $GP_{N+}$. Les transistors nMOS $MA_R$ et $MD_R$ sont réalisés sur une couche isolante BOX fine surplombant un autre plan de masse $GP_{N+}$. Le dopage des plans de masse $GP_{N+}$ est identique à celui de la source des transistors nMOS. Les plans de masse $GP_{N+}$ sont connectés au potentiel Vdd. La différence de potentiel entre ces plans de masse et la source des transistors nMOS est donc de Vdd. Par conséquent, on obtient une tension de seuil rabaissée Vtl pour les transistors nMOS (cf Tableau de la figure 4).

Les transistors de charge $ML_L$ et $ML_R$ de type pMOS sont réalisés sur la couche isolante BOX et surplombent un plan de masse $GP_{P+}$. Le dopage des plans de masse $GP_{P+}$ est identique à celui de la source des transistors pMOS $ML_L$ et $ML_R$. Une différence de potentiel de Vdd entre le plan de masse $GP_{P+}$ et la source des transistors $ML_L$ et $ML_R$ est appliquée. Par conséquent, on obtient une tension de seuil rabaissée Vtl pour les transistors pMOS (cf Tableau de la figure 4).

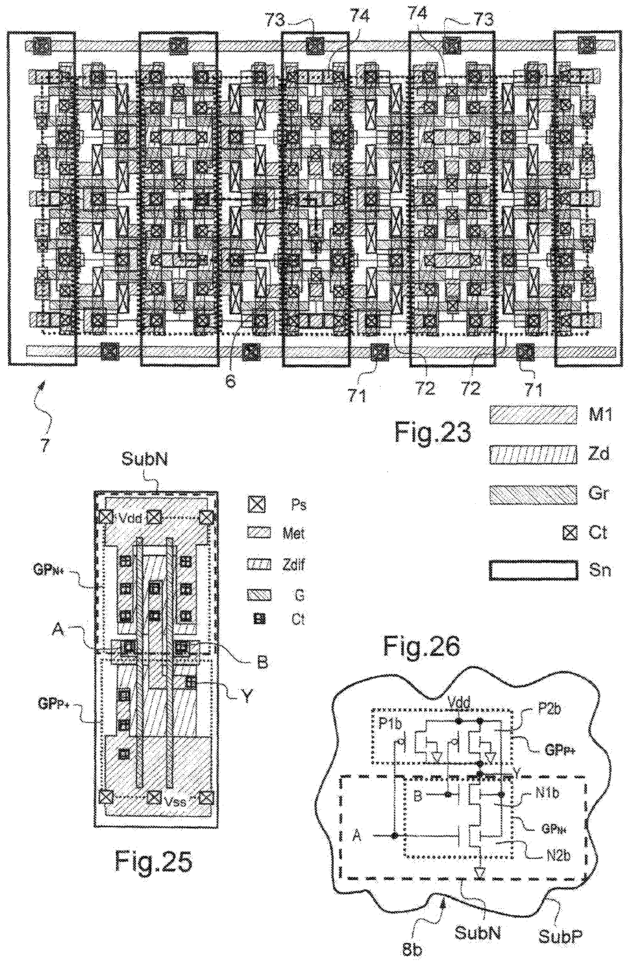

La figure 23 est une topologie d'une matrice 7 de 4 par 4 cellules mémoire 6. Les références 72 désignent les plans de masse de type P+. Les plans de masse 72 sont polarisés par l'intermédiaire des points de contact 71. Les références 74 désignent les plans de masse de type N+. Les plans de masse 74 sont polarisés par l'intermédiaire des points de contact 73. Dans la légende, les zones identifiées par M1 correspondent aux zones de métallisation. Les zones identifiées par Gr correspondent à des grilles. Les zones identifiées par Zd correspondent à des zones de diffusion. Les zones identifiées par Sn correspondent à des implantations de caissons de substrat de type N.

Le tableau suivant fournit des résultats de simulations réalisées pour une cellule mémoire 4 et une cellule mémoire 6.

| Cellule : | SNM (mV) | RNM (mV) | $I_{CELL}$ (µA/µm) | $I_{LEAK}$ (pA/µm) |
|---|---|---|---|---|
| 6 | 195 | 339.8 | **26.5** | 15092 |
| 4 | 274.6 | 441.9 | 11.8 | **0.235** |

Conformément aux attentes, on constate que le courant de fuite d'une cellule 4 est très inférieur au courant de fuite d'une cellule 6. La cellule mémoire 4 munie de transistors à tension de seuil relevée présente ainsi une consommation électrique réduite en rétention. Le courant de fuite de la cellule mémoire 6 pourra cependant être réduit en augmentant l'épaisseur de la couche isolante BOX. De plus, cette cellule mémoire 4 présente une stabilité en lecture et en écriture supérieure à la cellule mémoire 6. Conformément aux attentes, on constate également que le courant de lecture de la cellule mémoire 6 est supérieur au courant de lecture de la cellule mémoire 4. Par conséquent, la vitesse d'accès aux noeuds de stockage de la cellule 6 est supérieure.

L'invention permet ainsi de réaliser sur un même circuit intégré deux types de cellules mémoire présentant des propriétés distinctes à partir d'une même technologie, en différent pour l'essentiel le dopage et la polarisation des plans de masse des transistors de ces cellules mémoire. Bien que les exemples de cellules mémoire des figures 18 et 21 utilisent des transistors de charge $ML_L$ et $ML_R$ de type pMOS et des transistors d'accès $MA_L$ et $MA_R$ et deux transistors de conduction $MD_L$ et $MD_R$ de type nMOS, les cellules mémoire de type 6T peuvent également être réalisées en logique inverse.

Les cellules mémoire 4 à faible consommation et les cellules mémoire 6 à accès rapide seront par exemple intégrées dans un circuit mémoire. Les cellules mémoire 4 pourront être utilisées pour des applications basse consommation et les cellules mémoire 6 pourront être utilisées pour des applications nécessitant une plus grande bande passante de calculs.

L'invention s'applique avantageusement à des circuits intégrés comprenant des portes logiques devant présenter des propriétés électriques distinctes.

La figure 24 est un schéma électrique d'une porte logique 8a destinée à présenter une consommation électrique réduite. Des transistors pMOS P1a et P2a et des transistors nMOS N1a et N2a sont connectés de façon connue en soi pour former une porte NAND2 présentant une borne de sortie Y. Des bornes de commande A et B commandent respectivement les grilles des transistors P1a, N2a et P2a, N1a. Les transistors pMOS et nMOS surplombent une couche d'isolant fine, permettant la modulation des tensions de seuil comme détaillé auparavant. Les transistors pMOS sont réalisés sur un substrat subN dont le dopage est de type N, ce substrat étant implanté sous forme de caisson dans un substrat de type P par défaut. Les transistors pMOS sont réalisés à l'aplomb d'un plan de masse GPn+ dont le dopage est de type N. La différence de potentiel entre le plan de masse GPn+ et la source des transistors pMOS est nulle. Par conséquent, les transistors pMOS présentent une tension de seuil relevée (cf figure 4). Les transistors nMOS sont réalisés sur un substrat subP dont le dopage est de type P. Les transistors nMOS sont réalisés à l'aplomb d'un plan de masse GPp+ dont le dopage est de type P. La différence de potentiel entre le plan de masse GPp+ et la source des transistors nMOS est sensiblement nulle. Par conséquent, les transistors nMOS présentent une tension de seuil relevée (cf figure 4).

La figure 25 représente un exemple de dessin pour la porte logique 8a. Les zones identifiées par Ps correspondent à des contacts électriques de substrats. Dans cet exemple, les contacts électriques de substrat sont implémentés dans la cellule de la porte logique et directement connectés à Vdd ou à la masse. Les contacts électriques de substrat peuvent également être réalisés à l'extérieur de la cellule afin d'accroître la densité en portes logique du circuit intégré. La zone Met correspond à une zone de métallisation. La zone Zdif correspond à une zone de diffusion. La zone G correspond à la grille des transistors. La zone Ct correspond à des contacts. La partie surplombant le plan de masse GPp+ correspond aux transistors nMOS, tandis que la partie surplombant le plan de masse GPn+ correspond aux transistors pMOS.

La figure 26 est un schéma électrique d'une porte logique 8b destinée à présenter un courant de conduction élevé. Des transistors pMOS P1b et P2b et des transistors nMOS N1b et N2b sont connectés de façon connue en soi pour former une porte NAND2 présentant une borne de sortie Y. Des bornes de commande A et B commandent respectivement les grilles des transistors P1b, N2b et P2b, N1b. Les transistors pMOS et nMOS surplombent une couche d'isolant fine, permettant la modulation de leur tension de seuil comme détaillé auparavant. Les transistors pMOS sont réalisés sur un substrat subP dont le dopage est de type P. Les transistors pMOS sont réalisés à l'aplomb d'un plan de masse GPp+ dont le dopage est de type P. La différence de potentiel entre le plan de masse GPp+ et la source des transistors pMOS est de Vdd (connexion du substrat à la masse). Par conséquent, les transistors pMOS présentent une tension de seuil rabaissée (cf figure 4). Les transistors nMOS sont réalisés sur un substrat subN dont le dopage est de type N, ce substrat étant implanté dans le substrat de type P. Les transistors nMOS sont réalisés à l'aplomb d'un plan de masse GPn+ dont le dopage est de type N. La différence de potentiel entre le plan de masse GPn+ et la source des transistors nMOS est de Vdd (connexion du substrat à Vdd). Par conséquent, les transistors nMOS présentent une tension de seuil rabaissée (cf figure 4).

La figure 27 représente un exemple de topologie pour la porte logique 8b. La zone Met correspond à une zone de métallisation. La zone Zdif correspond à une zone de diffusion. La zone G correspond à la grille des transistors. La zone Ct correspond à des contacts. La partie surplombant le plan de masse GPn+ correspond aux transistors nMOS, tandis que la partie surplombant le plan de masse GPp+ correspond aux transistors pMOS.

La figure 28 représente schématiquement la disposition de différentes portes logiques de ces deux différentes sortes sur un circuit intégré 9. Les portes logiques ou cellules Cel peuvent être réalisées de façon à former des bandes présentant un même type de transistors disposés sur un plan de masse commun. Des rangées de cellules logiques sont séparées par des zones Ps de contact électrique. On disposera ainsi d'une bande de plan de masse dopée P surplombée par des transistors nMOS, d'une bande de plan de masse dopée P surplombée par des transistors pMOS, d'une bande de plan de masse dopée N surplombée par des transistors nMOS et d'une bande de plan de masse dopée N surplombée par des transistors pMOS. Les plans de masse dopés P sont connectés à Vdd, tandis que les plans de masse dopés N sont connectés à la masse, ce qui simplifie la connectique d'alimentation.

Le circuit 9 peut ainsi présenter des portes logiques présentant différentes caractéristiques électriques, sans pour autant complexifier son processus de fabrication. Il n'est notamment pas nécessaire d'utiliser différents types de métaux pour réaliser les grilles des transistors du circuit 9.

Pour l'ensemble des circuits intégrés décrits dans la présente demande, on peut réaliser des grilles dites de type midgap en langue anglaise (dont le travail de sortie se situe au milieu du travail de sortie du silicium) à la fois pour les nMOS et les pMOS. Le travail de sortie de grilles midgap est généralement d'environ 4,65 eV.

Il est également possible de moduler les tensions de seuil des transistors de ces circuits intégrés en utilisant des grilles présentant un travail de sortie de type P, par exemple de 4,85 eV. Il est encore possible de moduler les tensions de seuil des transistors en utilisant des grilles présentant un travail de sortie de type N, par exemple de 4,45 eV. De tels travaux de sortie des grilles permettront notamment d'obtenir des tensions de seuil accrues (nommées SVth par la suite) et des tensions de seuil rabaissées (nommées SVtl par la suite).

Il est également possible d'inclure des transistors exempts de plan de masse dans le circuit intégré.

Le tableau suivant récapitule différentes variantes de transistors basées sur la variation des travaux de sortie.

| Ref | Type | Travail de sortie | Dopage du Plan de masse | Type de Caisson | Polarisation du Plan de masse | Tension de seuil |
|-----|------|-------------------|-------------------------|-----------------|-------------------------------|------------------|
| 201 | NMOS | Type N | N | N | \|Vdd\| | SVtl |
| 202 | PMOS | Type P | P | P | 0 | SVtl |
| 203 | NMOS | Type N | N | P | 0 | Vtl |
| 204 | NMOS | Midgap | N | N | \|Vdd\| | Vtl |
| 205 | PMOS | Type P | P | N | \|Vdd\| | Vtl |
| 206 | PMOS | Midgap | P | P | 0 | Vtl |
| 207 | NMOS | Type N | P | P | 0 | Vt |
| 208 | NMOS | Type P | N | N | \|Vdd\| | Vt |
| 209 | NMOS | Midgap | N | P | 0 | Vt |
| 210 | NMOS | Midgap | P | N | \|Vdd\| | Vt |
| 211 | NMOS | Midgap | Sans | | 0 | Vt |
| 212 | NMOS | Midgap | Sans | | \|Vdd\| | Vt |
| 213 | PMOS | Type P | N | N | \|Vdd\| | Vt |
| 214 | PMOS | Type N | P | P | 0 | Vt |
| 215 | PMOS | Midgap | P | N | \|Vdd\| | Vt |
| 216 | PMOS | Midgap | N | P | 0 | Vt |
| 217 | PMOS | Midgap | Sans | | 0 | Vt |
| 218 | PMOS | Midgap | Sans | | \|Vdd\| | Vt |
| 219 | NMOS | Type P | N | P | 0 | Vth |
| 220 | NMOS | Midgap | P | P | 0 | Vth |
| 221 | PMOS | Type N | P | N | \|Vdd\| | Vth |
| 222 | PMOS | Midgap | N | N | \|Vdd\| | Vth |
| 223 | NMOS | Type P | P | P | 0 | SVth |
| 224 | PMOS | Type N | N | N | \|Vdd\| | SVth |

Pour un nMOS :

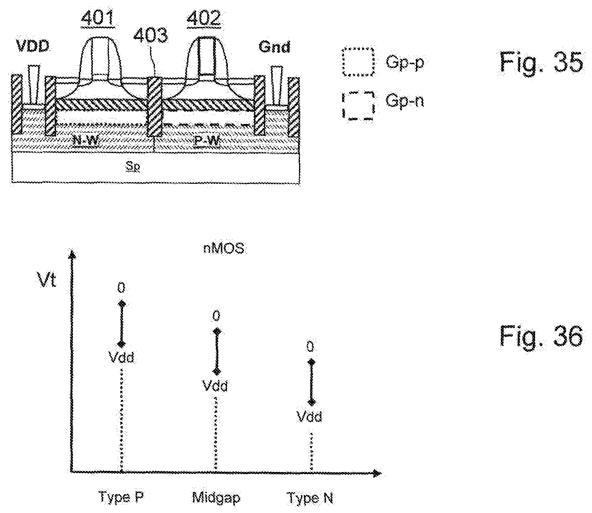

- l'utilisation d'une grille présentant un travail de sortie de type P permet d'augmenter la valeur minimale et la valeur maximale de la plage de seuil de tension en fonction de la polarisation, par rapport à un même transistor à grille de type midgap ;
- l'utilisation d'une grille présentant un travail de sortie de type N permet de réduire la valeur minimale et la valeur maximale de la plage de seuil de tension en fonction de la polarisation du plan de masse, par rapport à un même transistor à grille de type midgap. Le diagramme de la figure 36 illustre schématiquement des plages de tension de seuil respectives en fonction de la polarisation du plan de masse pour des transistors nMOS de type midgap, de type P et de type N.

Pour un pMOS :

- l'utilisation d'une grille présentant un travail de sortie de type N permet d'augmenter la valeur minimale et la valeur maximale de la plage de seuil de tension en fonction de la polarisation, par rapport à un même transistor à grille de type midgap ;
- l'utilisation d'une grille présentant un travail de sortie de type P permet de réduire la valeur minimale et la valeur maximale de la plage de seuil de tension en fonction de la polarisation du plan de masse, par rapport à un même transistor à grille de type midgap.

De tels transistors sont avantageusement combinés pour former des circuits intégrant des portes logiques avec une très grande densité. La formation de portes logiques implique l'association de nMOS et de pMOS accolés. Lorsque l'on souhaite accoler des portes logiques munies de transistors à tensions de seuil distinctes, on dispose les nMOS et les pMOS selon des rangées alternées. Pour accoler un couple nMOS/pMOS à tension de seuil Vth à un couple nMOS/pMOS à tension de seuil Vtl avec les règles détaillées à la figure 4 et des grilles de type midgap, il est nécessaire de réaliser des caissons n et p selon un motif en damier pour appliquer une polarisation appropriée sur chaque plan de masse. Ce motif nécessite la formation de tranchées d'isolation qui réduisent sensiblement la densité d'intégration des portes logiques.

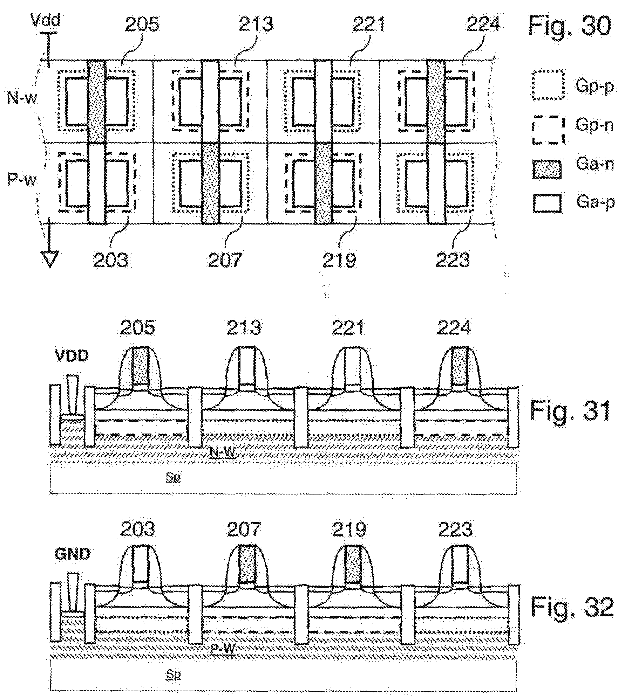

La figure 30 illustre schématiquement un exemple de circuit intégré comprenant des transistors à différentes tensions de seuil. Dans cette structure, les transistors nMOS sont disposés selon une rangée, et les transistors pMOS sont disposés selon une rangée accolée. Les références des transistors sur la figure 30 correspondent aux références du tableau ci-dessus. Les transistors nMOS correspondent aux références 203 (Vtl), 207 (Vt), 219 (Vth) et 223 (SVth), illustrés en coupe à la figure 32. Les transistors pMOS correspondent aux références 205 (Vtl), 213 (Vt), 221 (Vth) et 224 (SVth), illustrés en coupe à la figure 31. Une telle structure permet de réaliser un même caisson p (P-w) sous forme de bande sous une rangée de nMOS et de lui appliquer une polarisation commune, par exemple à la masse. Une telle structure permet également de réaliser un même caisson n (N-w) sous forme de bande sous une rangée de pMOS et de lui appliquer une polarisation commune, par exemple à Vdd. La densité d'intégration des transistors peut ainsi être optimisée en limitant l'utilisation des tranchées d'isolation. Gp-p désigne un plan de masse à dopage de type p. Gp-n désigne un plan de masse à dopage de type n. Ga-n désigne une grille à travail de sortie de type N. Ga-p désigne une grille à travail de sortie de type P.

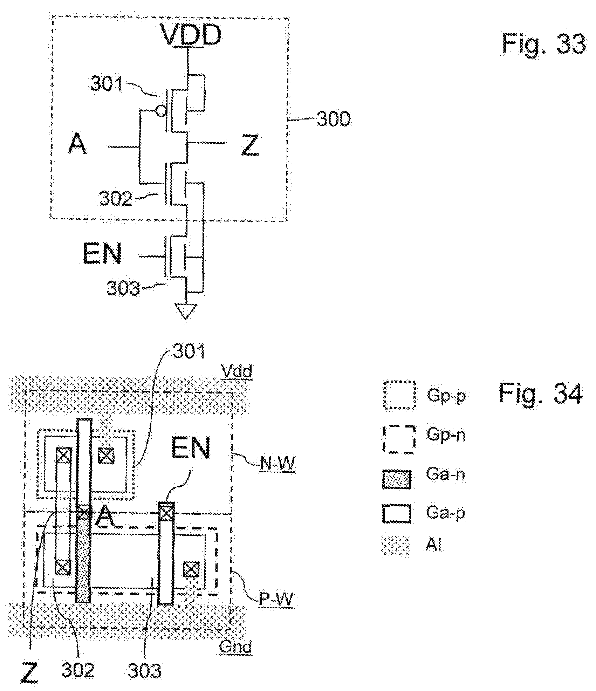

La figure 33 illustre un circuit intégré incluant des transistors de différents types. Le circuit comprend un module logique 300 connecté entre une tension Vdd et une tension de masse. Le module logique 300 inclut notamment des transistors 301 et 302 à tension de seuil rabaissée, afin de disposer d'une vitesse de commutation optimale durant son fonctionnement. Les transistors 301 et 302 sont connectés pour former un inverseur. Le transistor 301 est un transistor de type pMOS, le transistor 302 étant un transistor de type nMOS. Le module logique est connecté par l'intermédiaire d'au moins un transistor 303 à tension de seuil relevée à une ligne de masse. Le signal de commande EN sur la grille du transistor 303 permet de rendre celui-ci sélectivement passant ou bloqué. Le transistor 303 a une tension de seuil relevée permettant de limiter très fortement le courant de fuite lorsque le module logique n'est pas opérationnel, afin de minimiser sa consommation électrique, lorsque le transistor 303 est bloqué. Les transistors 301 et 302 à tension de seuil rabaissée permet de bénéficier d'un temps d'accès réduit lorsque le module logique 300 est en fonctionnement, lorsque le transistor 303 est passant.

Un transistor à tension de seuil relevée peut également connecter le module logique 300 à une tension Vdd afin de réduire le courant de fuite. Le module logique 300 peut également être connecté aux tensions Vdd et de masse par des transistors à tension de seuil relevée respectifs.

La figure 34 représente schématiquement un exemple de topologie d'intégration des transistors 301 et 303. Les lignes identifiées par Al correspondent à des lignes d'alimentation connectées respectivement à Vdd et la tension de masse. Comme illustré, les transistors 302 et 303 sont ménagés sur un caisson à dopage de type P et présentent un plan de masse à dopage de type N. Le plan de masse des transistors 302 et 303 est polarisé à une tension de masse. Le transistor 301 est réalisé sur un caisson à dopage de type N et présente un plan de masse à dopage de type P. Le plan de masse du transistor 301 est polarisé à Vdd. Les transistors 301 et 303 ont des grilles à travaux de sortie de type P. Le transistor 302 a une grille à travail de sortie de type N.

La figure 35 est une vue en coupe de deux transistors accolés présentant une tension de seuil standard Vt. Le transistor 401 est de type nMOS, le transistor 402 étant de type pMOS. Le transistor nMOS 401 présente un plan de masse à dopage de type P, polarisé par une tension Vdd. Le transistor pMOS 402 présente un plan de masse à dopage de type N, polarisé par une tension de masse.

Si ces transistors étaient réalisés en utilisant des grilles présentant les mêmes travaux de sortie, en jouant uniquement sur la tension de leur plan de masse et sur le dopage de leur plan de masse, les polarisations appliquées sur le plan de masse respectif des transistors généreraient, sous la couche d'isolant du fait que ces transistors sont accolés, une jonction PN polarisée en direct court-circuitant l'alimentation avec la masse.

Pour éviter ce problème, les transistors 401 et 402 sont réalisés respectivement sur des caissons à dopage de type N et à dopage de type P. Les transistors 401 et 402 sont également séparés par une tranchée d'isolation 403, s'étendant de la couche active jusqu'à la jonction entre les caissons N-W et P-W.

Bien que seuls quelques types de portes logiques aient été illustrés, l'invention s'applique bien entendu à tout autre type de porte logique.

Bien que l'invention ait été décrite jusqu'alors dans des applications numériques, on peut également appliquer l'invention à des circuits analogiques comprenant des transistors utilisés en régime linéaire.

Dans les exemples de transistors détaillés auparavant, la différence de potentiel entre le plan de masse et la source est comprise entre une valeur nulle et une valeur Vdd pour un nMOS, et entre une valeur nulle et une valeur -Vdd pour un pMOS. On peut cependant également envisager d'appliquer une valeur de différence de potentiel supérieure à Vdd pour un nMOS, ou inférieure à -Vdd pour un pMOS : la valeur de la tension de seuil est alors davantage réduite. On peut également envisager d'appliquer une valeur de différence de potentiel inférieure à 0 pour un nMOS, ou supérieure à 0 pour un pMOS : la valeur de la tension de seuil est alors davantage augmentée.

**Revendications**

1. Circuit intégré (2) comprenant une couche active semi-conductrice séparée d'une couche substrat semi-conductrice (101) par une couche de matériau isolant enterrée (103), comprenant des transistors PMOS et NMOS, **caractérisé en ce qu'**il comprend :

   - des premier et deuxième transistors d'un même type, PMOS ou NMOS ;
   - des premier et deuxième plans de masse disposés à l'aplomb respectivement des premier et deuxième transistors entre la couche de matériau isolant enterrée (103) et la couche substrat de silicium (101);

   et **en ce que** :

   - le premier transistor présente un type de dopage de son plan de masse opposé à celui de sa source, et présente une première tension de seuil (Vth) ;
   - le deuxième transistor présente un type de dopage de son plan de masse identique à celui de sa source, et présente une deuxième tension de seuil (Vtl) ;
   - la première tension de seuil est fonction de la différence de potentiel appliquée entre la source et le plan de masse du premier transistor ;
   - la deuxième tension de seuil est fonction de la différence de potentiel appliquée entre la source et le plan de masse du deuxième transistor ;
   - les première et deuxième tensions de seuil pouvant varier respectivement dans une première et une deuxième plage de tensions dans le cas où la différence de potentiel entre le plan de masse et la source du premier ou deuxième transistor varie entre une valeur nulle et une valeur égale à la tension d'alimentation du circuit;
   - l'épaisseur de la couche de matériau isolant (103) est suffisamment fine pour que la valeur maximale de la première plage soit supérieure d'au moins 10% à la valeur minimale de la première plage, et la valeur minimale de la deuxième plage soit inférieure d'au moins 10% à la valeur maximale de la deuxième plage.

2. Circuit intégré selon la revendication 1, dans lequel la valeur maximale de la première plage est supérieure à la valeur maximale de la deuxième plage.

3. Circuit intégré selon la revendication 2, dans lequel la valeur maximale de la première plage est supérieure d'au moins 40mV à la valeur minimale de la première plage, et dans lequel la valeur minimale de la deuxième plage est inférieure d'au moins 40mV à la valeur maximale de la deuxième plage.

4. Circuit intégré selon l'une quelconque des revendications précédentes, dans lequel l'épaisseur de la couche de matériau isolant enterrée au niveau des premier et deuxième transistors est suffisamment fine de sorte que la première tension de seuil est supérieure à la deuxième tension de seuil lorsqu'une même différence de potentiel de référence est appliquée entre la source et le plan de masse des premier et deuxième transistors.

5. Circuit intégré selon l'une quelconque des revendications précédentes, dans lequel les premier et deuxième transistors présentent des grilles respectives réalisées dans le même type de métal.

6. Circuit intégré selon la revendication 5, dans lequel les premier et deuxième transistors présentent une structure identique à l'exception du dopage de leur plan de masse.

7. Circuit intégré selon l'une quelconque des revendications 1 à 4, dans lequel les premier et deuxième transistors présentent des grilles respectives réalisées dans des métaux respectifs présentant des travaux de sortie distincts.

8. Circuit intégré selon l'une quelconque des revendications précédentes, comprenant une mémoire incluant :

- au moins une ligne de mot (WL) ;
- au moins deux lignes de bit ($BL_R$, $BL_L$) ;
- une cellule mémoire de type 4T (2) incluant des troisième ($MD_L$) et quatrième ($MA_L$) transistors et incluant également des cinquième ($MD_R$) et sixième ($MA_R$) transistors, le cinquième transistor présentant une structure similaire à celle du troisième transistor pour présenter une même tension de seuil, le sixième transistor présentant une structure similaire à celle du quatrième transistor pour présenter une même tension de seuil, les troisième ($MD_L$) et quatrième ($MA_L$) transistors étant de types opposés, les troisième ($MD_L$) et cinquième transistors ($MD_R$) étant connectés pour former une bascule bistable présentant deux noeuds de stockage, les quatrième ($MA_L$) et sixième ($MA_R$) transistors étant commandés par la ligne de mot pour connecter sélectivement les noeuds de la bascule bistable à des lignes de bit respectives.

9. Circuit intégré selon la revendication 8, dans lequel la différence de potentiel entre la source des troisième et cinquième transistors et leur plan de masse respectif est sensiblement nulle, et dans lequel la différence de potentiel entre la source des quatrième et sixième transistors et leur plan de masse respectif est sensiblement égale à une tension Vdd.

10. Circuit intégré selon l'une quelconque des revendications 1 à 7, comprenant une mémoire incluant :

   - au moins une ligne de mot (WL) ;
   - au moins deux lignes de bit ($BL_R$, $BL_L$) ;
   - une cellule mémoire de type 4T (2) incluant des troisième ($MD_L$) et quatrième ($MA_L$) transistors et incluant également des cinquième ($MD_R$) et sixième ($MA_R$) transistors, les troisième à sixième transistors étant disposés à l'aplomb de plans de masse respectifs entre la couche de matériau isolant enterrée (103) et la couche substrat de silicium (101), le cinquième transistor étant du même type que le troisième transistor, le sixième transistor étant du même type que le quatrième transistor, les troisième ($MD_L$) et quatrième ($MA_L$) transistors étant de types opposés, les troisième ($MD_L$) et cinquième transistors ($MD_R$) étant connectés pour former une bascule bistable présentant deux noeuds de stockage, les plans de masse des troisième et quatrième transistors étant connectés à la grille du troisième transistor et les plans de masse des cinquième et sixième transistors étant connectés à la grille du cinquième transistor, les quatrième ($MA_L$) et sixième ($MA_R$) transistors étant commandés par la ligne de mot pour connecter sélectivement les noeuds de la bascule bistable à des lignes de bit respectives.

11. Circuit intégré selon l'une quelconque des revendications 1 à 7, comprenant une mémoire incluant des première (4) et deuxième (6) cellules mémoire de type 6T présentant chacune, une ligne de mot, deux lignes de bit, deux transistors de charge ($ML_L$, $ML_R$) et deux transistors de conduction ($MD_L$, $MD_R$) connectés pour former une bascule bistable présentant deux noeuds de stockage, chaque cellule mémoire comprenant en outre deux transistors d'accès ($MA_L$, $MA_R$) commandés par la ligne de mot pour connecter sélectivement les noeuds de la bascule bistable aux lignes de bit respectives, le premier transistor formant un transistor d'accès de la première cellule mémoire (4) et le deuxième transistor formant un transistor d'accès de la seconde cellule mémoire (6).

12. Circuit intégré la revendication 11, dans lequel les transistors de conduction ($MD_L$, $MD_R$) des cellules mémoire présentent un type de dopage de leur plan de masse identique à celui du plan de masse de leur transistor d'accès, une épaisseur de la couche de matériau isolant (103) identique à celle de leur transistor d'accès et une polarisation de leur plan de masse identique à celle du plan de masse de leur transistor d'accès.

13. Circuit intégré selon la revendication 12, dans lequel un plan de masse est commun pour un transistor de conduction et pour un transistor d'accès d'une des cellules mémoire.

14. Circuit intégré selon l'une quelconque des revendications précédentes, comprenant des première (8a) et deuxième (8b) portes logiques, chaque porte logique comprenant au moins deux transistors commandés par des bornes d'entrée (A,B) respectives, ledit premier transistor (N1a) formant un desdits transistors de la première porte logique (8a) et ledit second transistor (N1b) formant un desdits transistors de la deuxième porte logique (8b).

15. Circuit intégré selon la revendication 14, dans lequel lesdits premier et deuxième transistors sont de type nMOS.

16. Circuit intégré selon la revendication 15, dans lequel la différence de potentiel entre le plan de masse du premier transistor et sa source est nulle, et dans lequel la différence de potentiel entre le plan de masse du second transistor et sa source est égale à une tension Vdd.

**17.** Circuit intégré selon l'une quelconque des revendications précédentes, dans lequel la couche de matériau isolant enterrée (103) présente une épaisseur inférieure à 50nm et dans lequel la largeur de la grille desdits transistors est inférieure à 50nm.

**18.** Circuit intégré selon l'une quelconque des revendications précédentes, dans lequel la couche de matériau isolant enterrée (103) présente une épaisseur inférieure à la longueur de grille d'un desdits transistors.

**19.** Circuit intégré selon l'une quelconque des revendications précédentes, comprenant un septième transistor ménagé dans la couche active semi-conductrice, ce septième transistor étant dépourvu de plan de masse entre la couche de matériau isolant enterrée et la couche substrat de silicium à son aplomb.

**20.** Circuit intégré selon l'une quelconque des revendications précédentes, comprenant un huitième transistor (401) de type nMOS et un neuvième transistor (402) de type pMOS,

    - des huitième et neuvième plans de masse disposés à l'aplomb respectivement des huitième et neuvième transistors entre la couche de matériau isolant enterrée (103) et la couche substrat de silicium (101), le huitième plan de masse présentant un dopage de type P et le neuvième plan de masse présentant un dopage de type N ;
    - un caisson à dopage de type N (N-W) séparant le huitième plan de masse de la couche substrat de silicium ;
    - un caisson à dopage de type P (P-W) séparant le neuvième plan de masse de la couche substrat de silicium ;
    - une tranchée d'isolation (403) s'étendant de la couche active de silicium jusqu'auxdits caissons de façon à séparer les huitième et neuvième plans de masse.

**21.** Circuit intégré selon la revendication 20, dans lequel le caisson à dopage de type N est excité par une tension Vdd, et dans lequel le caisson à dopage de type P est connecté à une masse.

**22.** Circuit intégré selon l'une quelconque des revendications précédentes, comprenant un module logique (300) incluant le deuxième transistor (302), le premier transistor (303) raccordant le module logique à une tension d'alimentation, une différence de potentiel nulle étant appliquée entre la source et le plan de masse du premier transistor, une différence de potentiel d'une valeur nulle étant appliquée entre la source et le plan de masse du deuxième transistor.

**23.** Circuit intégré selon l'une quelconque des revendications précédentes, dans lequel les premier et deuxième transistors (205, 213) sont accolés, dans lequel les plans de masse des premier et deuxième transistors sont séparés de la couche substrat semi-conductrice (101) par un premier caisson (N-w) formant une bande et présentant un dopage d'un premier type, le premier caisson étant alimenté par un premier niveau de tension, le circuit intégré comprenant en outre des dizième et onzième transistors (203, 207) d'un type opposé aux premier et deuxième transistors, les dizième et onzième transistors étant accolés et présentant des plans de masse dont les types de dopage sont opposés, les plans de masse des dizième et onzième transistors étant séparés de la couche substrat semi-conductrice par un deuxième caisson (P-w) accolé au premier caisson et formant une bande, le deuxième caisson présentant un dopage d'un deuxième type opposé au premier type, le deuxième caisson étant alimenté par un deuxième niveau de tension, les premier et dizième transistors présentant des grilles respectives dont les travaux de sortie sont distincts, les deuxième et onzième transistors présentant des grilles respectives dont les travaux de sortie sont distincts.

**24.** Circuit intégré selon la revendication 23, dans lequel les premier (205) et dizième (203) transistors sont accolés et appartiennent à une même porte logique, et dans lequel les deuxième (213) et onzième (207) transistors sont accolés et appartiennent à une même porte logique, et dans lequel le type de dopage du plan de masse du premier transistor est opposé au type de dopage du plan de masse du dizième transistor, et dans lequel les premier et deuxième transistors présentent des grilles respectives dont les travaux de sortie sont distincts.

**Patentansprüche**

**1.** Integrierte Schaltung (2), die eine aktive Halbleiterschicht umfasst, die von einer Halbleiter-Substratschicht (101) durch eine vergrabene Schicht (103) aus Isoliermaterial getrennt ist, und PMOS- und NMOS-Transistoren umfasst, **gekennzeichnet durch**:

    - einen ersten und einen zweiten Transistor desselben Typs, PMOS oder NMOS;
    - eine erste und eine zweite Masseebene, die zwischen der vergrabenen Schicht (103) aus Isoliermaterial und der Siliciumsubstratschicht (101) senkrecht zu dem ersten bzw. dem zweiten Transistor angeordnet sind;

und **dadurch** dass

- der erste Transistor einen Dotierungstyp seiner Masseebene aufweist, der zu jenem seiner Source entgegengesetzt ist, und eine erste Schwellenspannung (Vth) aufweist;
- der zweite Transistor einen Dotierungstyp seiner Masseebene aufweist, der mit jenem seiner Source übereinstimmt, und eine zweite Schwellenspannung (Vtl) aufweist;
- die erste Schwellenspannung eine Funktion der Potenzialdifferenz ist, die zwischen die Source und die Masseebene des ersten Transistors angelegt wird;
- die zweite Schwellenspannung eine Funktion der Potenzialdifferenz, die zwischen die Source und die Masseebene des zweiten Transistors angelegt wird;
- die erste und die zweite Schwellenspannung sich in einem ersten bzw. einem zweiten Spannungsbereich verändern können, falls sich die Potenzialdifferenz zwischen der Masseebene und der Source des ersten oder des zweiten Transistors zwischen einem Wert null und einem Wert, der gleich der Versorgungsspannung der Schaltung ist, verändert;
- die Dicke der Schicht (103) aus Isoliermaterial ausreichend gering ist, damit der Maximalwert des ersten Bereichs um wenigstens 10 % größer als der Minimalwert des ersten Bereichs ist und der Minimalwert des zweiten Bereichs um wenigstens 10 % geringer als der Maximalwert des zweiten Bereichs ist.

2. Integrierte Schaltung nach Anspruch 1 wobei der Maximalwert des ersten Bereichs größer als der Maximalwert des zweiten Bereichs ist.

3. Integrierte Schaltung nach Anspruch 2, wobei der Maximalwert des ersten Bereichs um wenigstens 40 mV größer als der Minimalwert des ersten Bereichs ist und der Minimalwert des zweiten Bereichs um wenigstens 40 mV kleiner als der Maximalwert des zweiten Bereichs ist.

4. Integrierte Schaltung nach einem der vorhergehenden Ansprüche, wobei die Dicke der vergrabenen Schicht aus Isoliermaterial auf Höhe des ersten und des zweiten Transistors ausreichend gering ist, damit die erste Schwellenspannung größer als die zweite Schwellenspannung ist, wenn zwischen die Source und die Masseebene des ersten und des zweiten Transistors die gleiche Potenzialdifferenz angelegt wird.

5. Integrierte Schaltung nach einem der vorhergehenden Ansprüche, wobei der erste und der zweite Transistor jeweilige Gates aufweisen, die aus demselben Metalltyp verwirklicht sind.

6. Integrierte Schaltung nach Anspruch 5, wobei der erste und der zweite Transistor eine Struktur aufweisen, die mit Ausnahme der Dotierung ihrer Masseebene gleich ist.

7. Integrierte Schaltung nach einem der Ansprüche 1 bis 4, wobei der erste und der zweite Transistor jeweilige Gates aufweisen, die aus jeweiligen Metallen verwirklicht sind, die unterschiedliche Austrittsarbeiten besitzen.

8. Integrierte Schaltung nach einem der vorhergehenden Ansprüche, die einen Speicher umfasst, der Folgendes enthält:

- wenigstens eine Wortleitung (WL);
- wenigstens zwei Bitleitungen ($BL_R$, $BL_L$);
- eine Speicherzelle des Typs 4T (2), die einen dritten ($MD_L$) und einen vierten ($MA_L$) Transistor enthält und außerdem einen fünften ($MD_L$) und einen sechsten ($MA_R$) Transistor enthält, wobei der fünfte Transistor eine Struktur aufweist, die zu jener des dritten Transistors ähnlich ist, damit er die gleiche Schwellenspannung aufweist, wobei der sechste Transistor eine Struktur aufweist, die zu jener des vierten Transistors ähnlich ist, damit er die gleiche Schwellenspannung aufweist, wobei der dritte ($MD_L$) und der vierte ($MA_L$) Transistor vom entgegengesetzten Typ sind, wobei der dritte ($MD_L$) und der fünfte Transistor ($MD_R$) verbunden sind, um eine bistabile Kippschaltung zu bilden, die zwei Speicherknoten aufweist, wobei der vierte ($MA_L$) und der sechste ($MA_R$) Transistor durch die Wortleitung gesteuert werden, um die Knoten der bistabilen Kippschaltung wahlweise mit den entsprechenden Bitleitungen zu verbinden.

9. Integrierte Schaltung nach Anspruch 8, wobei die Potenzialdifferenz zwischen der Source des dritten und des fünften Transistors und ihrer jeweiligen Masseebene im Wesentlichen null ist und wobei die Potenzialdifferenz zwischen der Source des vierten und des sechsten Transistors und ihrer jeweiligen Masseebene im Wesentlichen gleich einer Spannung Vdd ist.

10. Integrierte Schaltung nach einem der Ansprüche 1 bis 7, die einen Speicher umfasst, der Folgendes enthält:

- wenigstens eine Wortleitung (WL);
- wenigstens zwei Bitleitungen ($BL_R$, $BL_L$);
- eine Speicherzelle des Typs 4T (2), der einen dritten ($MD_L$) und einen vierten ($MA_L$) Transistor enthält und außerdem einen fünften ($MD_R$) und einen sechsten ($MA_R$) Transistor enthält, wobei die dritten bis sechsten Transistoren senkrecht zu jeweiligen Masseebenen zwischen der vergrabenen Schicht (103) aus Isoliermaterial und der Siliciumsubstratschicht (101) angeordnet sind, wobei der fünfte Transistor vom selben Typ wie der dritte Transistor ist, wobei der sechste Transistor vom selben Typ wie der vierte Transistor ist, wobei der dritte ($MD_L$) und der vierte ($MA_L$) Transistor vom entgegengesetzten Typ sind, wobei der dritte ($MD_L$) und der fünfte ($MD_R$) Transistor verbunden sind, um eine bistabile Kippschaltung zu bilden, die zwei Speicherknoten aufweist, wobei die Masseebenen des dritten und des vierten Transistors mit dem Gate des dritten Transistors verbunden sind und wobei die Masseebenen des fünften und des sechsten Transistors mit dem Gate des fünften Transistors verbunden sind, wobei der vierte ($MA_L$) und der sechste ($MA_R$) Transistor durch die Wortleitung gesteuert werden, um die Knoten der bistabilen Kippschaltung wahlweise mit jeweiligen Bitleitungen zu verbinden.

11. Integrierte Schaltung nach einem der Ansprüche 1 bis 7, die einen Speicher umfasst, der eine erste (4) und eine zweite (6) Speicherzeile des Typs 6T enthält, die jeweils eine Wortleitung, zwei Bitleitungen, zwei Lasttransistoren ($ML_L$, $ML_R$) und zwei Leitungstransistoren ($MD_L$, $MD_R$) aufweisen, die jeweils verbunden sind, um eine bistabile Kippschaltung zu bilden, die zwei Speicherknoten aufweist, wobei jede Speicherzelle außerdem zwei Zugriffstransistoren ($MA_L$, $MA_R$) umfasst, die durch die Wortleitung gesteuert werden, um die Knoten der bistabilen Kippschaltung wahlweise mit den jeweiligen Bitleitungen zu verbinden, wobei der erste Transistor einen Zugriffstransistor der ersten Speicherzelle (4) bildet und der zweite Transistor einen Zugriffstransistor der zweiten Speicherzelle (6) bildet.

12. Integrierte Schaltung nach Anspruch 11, wobei die Leitungstransistoren ($MD_L$, $MD_R$) der Speicherzellen einen Dotierungstyp ihrer Masseebene aufweisen, der mit jenem der Masseebene ihres Zugriffstransistors übereinstimmt, wobei eine Dicke der Schicht (103) aus Isoliermaterial mit jener ihres Zugriffstransistors übereinstimmt und eine Polarisation ihrer Masseebene mit jener der Masseebene ihres Zugriffstransistors übereinstimmt.

13. Integrierte Schaltung nach Anspruch 12, wobei die Masseebene einem Leitungstransistor und einem Zugriffstransistor einer der Speicherzellen gemeinsam ist.

14. Integrierte Schaltung nach einem der vorhergehenden Ansprüche, die ein erstes (8a) und ein zweites (8b) Logikgatter umfasst, wobei jedes Logikgatter wenigstens zwei Transistoren enthält, die durch entsprechende Eingangsanschlüsse (A, B) gesteuert werden, wobei der erste Transistor (N1 a) einen der Transistoren des ersten Logikgatters (8a) bildet und der zweite Transistor (N1b) einen der Transistoren des zweiten Logikgatters (8b) bildet.

15. Integrierte Schaltung nach Anspruch 14, wobei der erste und der zweite Transistor vom nMOS-Typ sind.

16. Integrierte Schaltung nach Anspruch 15, wobei die Potenzialdifferenz zwischen der Masseebene des ersten Transistors und seiner Source gleich null ist und wobei die Potenzialdifferenz zwischen der Masseebene des zweiten Transistors und seiner Source gleich einer Spannung Vdd ist.

17. Integrierte Schaltung nach einem der vorhergehenden Ansprüche, wobei die vergrabene Schicht (103) aus Isoliermaterial eine Dicke aufweist, die geringer als 50 nm ist, wobei die Breite des Gate der Transistoren kleiner als 50 nm ist.

18. Integrierte Schaltung nach einem der vorhergehenden Ansprüche, wobei die vergrabene Schicht (103) aus Isoliermaterial eine Dicke aufweist, die kleiner als die Länge des Gate eines der Transistoren ist.

19. Integrierte Schaltung nach einem der vorhergehenden Ansprüche, die einen siebten Transistor umfasst, der in der aktiven Halbleiterschicht ausgebildet ist, wobei dieser siebte Transistor zwischen der vergrabenen Schicht aus Isoliermaterial und der Siliciumsubstratschicht keine hierzu senkrechte Masseebene besitzt.

20. Integrierte Schaltung nach einem der vorhergehenden Ansprüche, die einen achten Transistor (401) vom nMOS-Typ und einen neunten Transistor (402) vom pMOS-Typ umfasst,

- wobei die achte und die neunte Masseebene senkrecht zu dem achten bzw. dem neunten Transistor zwischen der vergrabenen Schicht (103) aus Isoliermaterial und der Siliciumsubstratschicht (101) angeordnet sind, wobei die achte Masseebene einen P-Dotierungstyp aufweist und die neunte Masseebene einen N-Dotierungstyp aufweist;
- wobei eine Wanne vom N-Dotierungstyp (N-W) die achte Masseebene von der Siliciumsubstratschicht trennt;
- wobei eine Wanne vom P-Dotierungstyp (P-W) die neunte Masseebene von der Siliciumsubstratschicht trennt;
- wobei sich ein Isolationsgraben (403) von der aktiven Siliciumsubstratschicht bis zu den Wannen erstreckt, derart, dass er die achte und die neunte Masseebene voneinander trennt.

21. Integrierte Schaltung nach Anspruch 20, wobei die Wanne vom N-Dotierungstyp durch eine Spannung Vdd erregt wird und wobei die Wanne vom P-Dotierungstyp mit Masse verbunden ist.

22. Integrierte Schaltung nach einem der vorhergehenden Ansprüche, die ein Logikmodul (300) umfasst, das den zweiten Transistor (302) enthält, wobei der erste Transistor (303) das Logikmodul mit einer Versorgungsspannung verbindet, wobei eine Potenzialdifferenz von null zwischen die Source und die Masseebene des ersten Transistors angelegt wird und wobei eine Potenzialdifferenz mit einem Wert null zwischen die Source und die Masseebene des zweiten Transistors angelegt wird.

23. Integrierte Schaltung nach einem der vorhergehenden Ansprüche, wobei der erste und der zweite Transistor (205, 213) aneinander gefügt sind, wobei die Masseebenen des ersten und des zweiten Transistors von der Halbleitersubstratschicht (101) durch eine erste Wanne (N-w) getrennt ist, die Streifen bildet und eine Dotierung eines ersten Typs aufweist, wobei die erste Wanne durch einen ersten Spannungspegel versorgt wird, wobei die integrierte Schaltung außerdem einen zehnten und einen elften Transistor (203, 207) eines Typs, der zu jenem des ersten und des zweiten Transistors entgegengesetzt ist, umfasst, wobei der zehnte und der elfte Transistor aneinander gefügt sind und Masseebenen aufweisen, deren Dotierungstypen entgegengesetzt sind, wobei die Masseebenen des zehnten und des elften Transistors von der Halbleitersubstratschicht durch eine zweite Wanne (P-w) getrennt sind, die an die erste Wanne angefügt ist und einen Streifen bildet, wobei die zweite Wanne eine Dotierung eines zweiten Typs, der dem ersten Typ entgegengesetzt ist, aufweist, wobei die zweite Wanne durch einen zweiten Spannungspegel versorgt wird, wobei der erste und der zehnte Transistor jeweilige Gates aufweisen, deren Austrittsarbeiten unterschiedlich sind, wobei der zweite und der elfte Transistor jeweils Gates aufweisen, deren Austrittsarbeiten unterschiedlich sind.

24. Integrierte Schaltung nach Anspruch 23, wobei der erste (205) und der zehnte (203) Transistor aneinander gefügt sind und zu demselben Logikgatter gehören und wobei der zweite (213) und der elfte (207) Transistor aneinander gefügt sind und zu demselben Logikgatter gehören und wobei der Dotierungstyp der Masseebene des ersten Transistors zu dem Dotierungstyp der Masseebene des zehnten Transistors entgegengesetzt ist und wobei der erste und der zweite Transistor jeweilige Gates aufweisen, deren Austrittsarbeiten unterschiedlich sind.

**Claims**

1. Integrated circuit (2) comprising a semiconductive active layer that is separated from a semiconductive substrate layer (101) by a buried layer of insulating material (103), comprising PMOS and NMOS transistors, **characterized in that** it comprises:

- first and second transistors of one and the same type, PMOS or NMOS;
- first and second ground planes that are positioned plumb with the first and second transistors, respectively, between the buried layer of insulating material (103) and the silicon substrate layer (101);

and **in that**:

- the first transistor has a type of doping of its ground plane that is the opposite of that of its source, and has a first threshold voltage (Vth);
- the second transistor has a type of doping of its ground plane that is identical to that of its source, and has a second threshold voltage (Vtl);
- the first threshold voltage is a function of the potential difference applied between the source and the ground plane of the first transistor;

- the second threshold voltage is a function of the potential difference applied between the source and the ground plane of the second transistor;

- the first and second threshold voltages are able to vary within a first and a second range of voltages, respectively, in the case in which the potential difference between the ground plane and the source of the first or second transistor varies between a zero value and a value that is equal to the supply voltage of the circuit;

- the thickness of the layer of insulating material (103) is sufficiently fine for the maximum value of the first range to be higher than the minimum value of the first range by at least 10%, and the minimum value of the second range to be lower than the maximum value of the second range by at least 10%.

2. Integrated circuit according to Claim 1, in which the maximum value of the first range is higher than the maximum value of the second range.

3. Integrated circuit according to Claim 2, in which the maximum value of the first range is higher than the minimum value of the first range by at least 40 mV, and in which the minimum value of the second range is lower than the maximum value of the second range by at least 40 mV.

4. Integrated circuit according to any one of the preceding claims, in which the thickness of the buried layer of insulating material at the level of the first and second transistors is sufficiently fine for the first threshold voltage to be higher than the second threshold voltage when one and the same reference potential difference is applied between the source and the ground plane of the first and second transistors.

5. Integrated circuit according to any one of the preceding claims, in which the respective gates of the first and second transistors are produced in the same type of metal.

6. Integrated circuit according to Claim 5, in which the first and second transistors have an identical structure apart from the doping of their ground plane.

7. Integrated circuit according to any one of Claims 1 to 4, in which the respective gates of the first and second transistors are produced in respective metals having separate work functions.

8. Integrated circuit according to any one of the preceding claims, comprising a memory including:

- at least one word line (WL);
- at least two bit lines ($BL_R$, $BL_L$);
- a memory cell of 4T type (2) including third ($MD_L$) and fourth ($MA_L$) transistors and also including fifth ($MD_R$) and sixth ($MA_R$) transistors, the fifth transistor having a structure that is similar to that of the third transistor in order to have one and the same threshold voltage, the sixth transistor having a structure that is similar to that of the fourth transistor in order to have one and the same threshold voltage, the third ($MD_L$) and fourth ($MA_L$) transistors being of opposite types, the third ($MD_L$) and fifth transistors ($MD_R$) being connected in order to form a bistable flip-flop having two storage nodes, the fourth ($MA_L$) and sixth ($MA_R$) transistors being controlled by the word line in order to selectively connect the nodes of the bistable flip-flop to respective bit lines.

9. Integrated circuit according to Claim 8, in which the potential difference between the source of the third and fifth transistors and their respective ground plane is substantially zero, and in which the potential difference between the source of the fourth and sixth transistors and their respective ground plane is substantially equal to a voltage Vdd.

10. Integrated circuit according to any one of claims 1 to 7, comprising a memory including:

- at least one word line (WL);
- at least two bit lines ($BL_R$, $BL_L$);
- a memory cell of 4T type (2) including third ($MD_L$) and fourth ($MA_L$) transistors and also including fifth ($MD_R$) and sixth ($MA_R$) transistors, the third to sixth transistors being positioned plumb with respective ground planes between the buried layer of insulating material (103) and the silicon substrate layer (101), the fifth transistor being of the same type as the third transistor, the sixth transistor being of the same type as the fourth transistor, the third ($MD_L$) and fourth ($MA_L$) transistors being of opposite types, the third ($MD_L$) and fifth ($MD_R$) transistors being connected in order to form a bistable flip-flop having two storage nodes, the ground planes of the third and fourth transistors being connected to the gate of the third transistor and the ground planes of the fifth and sixth transistors being connected to the gate of the fifth transistor, the fourth ($MA_L$) and sixth ($MA_R$) transistors being controlled by the word line in order to selectively connect the nodes of the bistable flip-flop to respective bit lines.

11. Integrated circuit according to any one of claims 1 to 7, comprising a memory including first (4) and second (6) memory cells of 6T type, each having one word line, two bit lines, two load transistors ($ML_L$, $ML_R$) and two conduction transistors ($MD_L$, $MD_R$) that are connected to form a bistable flip-flop having two storage nodes, each memory cell additionally comprising two access transistors ($MA_L$, $MA_R$) that are controlled by the word line in order to selectively connect the nodes of the bistable flip-flop to the respective bit lines, the first transistor forming an access transistor for accessing the first memory cell (4) and the second transistor forming an access transistor for accessing the second memory cell (6).

12. Integrated circuit according to Claim 11, in which the conduction transistors ($MD_L$, $MD_R$) of the memory cells have a type of doping of their ground plane that is identical to that of the ground plane of their access transistor, a thickness of the layer of insulating material (103) that is identical to that of their access transistor and a biasing of their ground plane that is identical to that of the ground plane of their access transistor.

13. Integrated circuit according to Claim 12, in which one ground plane is shared by one conduction transistor and one access transistor of one of the memory cells.

14. Integrated circuit according to any one of the preceding claims, comprising first (8a) and second (8b) logic gates, each logic gate comprising at least two transistors that are controlled by respective input terminals (A, B), said first transistor (N1 a) forming one of said transistors of the first logic gate (8a) and said second transistor (N1 b) forming one of said transistors of the second logic gate (8b).

15. Integrated circuit according to Claim 14, in which said first and second transistors are of nMOS type.

16. Integrated circuit according to Claim 15, in which the potential difference between the ground plane of the first transistor and its source is zero, and in which the potential difference between the ground plane of the second transistor and its source is equal to a voltage Vdd.

17. Integrated circuit according to any one of the preceding claims, in which the thickness of the buried layer of insulating material (103) is less than 50 nm and in which the width of the gate of said transistors is less than 50 nm.

18. Integrated circuit according to any one of the preceding claims, in which the thickness of the buried layer of insulating material (103) is less than the gate length of one of said transistors.

19. Integrated circuit according to any one of the preceding claims, comprising a seventh transistor that is embedded in the semiconductive active layer, this seventh transistor being without a ground plane between the buried layer of insulating material and the silicon substrate layer plumb therewith.

20. Integrated circuit according to any one of the preceding claims, comprising an eighth transistor (401) of nMOS type and a ninth transistor (402) of pMOS type,

- eighth and ninth ground planes that are positioned plumb with the eighth and ninth transistors, respectively, between the buried layer of insulating material (103) and the silicon substrate layer (101), the eighth ground plane having P-type doping and the ninth ground plane having N-type doping;
- an N-type doping well (N-W) separating the eighth ground plane from the silicon substrate layer;
- a P-type doping well (P-W) separating the ninth ground plane from the silicon substrate layer;
- an isolation trench (403) extending from the silicon active layer up to said wells so as to separate the eighth and ninth ground planes.

21. Integrated circuit according to Claim 20, in which the N-type doping well is excited by a voltage Vdd, and in which the P-type doping well is connected to a ground.

22. Integrated circuit according to any one of the preceding claims, comprising a logic module (300) including the second transistor (302), the first transistor (303) connecting the logic module to a supply voltage, a zero potential difference being applied between the source and the ground plane of the first transistor, a potential difference with a zero value being applied between the source and the ground plane of the second transistor.

23. Integrated circuit according to any one of the preceding claims, in which the first and second transistors (205, 213) are adjoined, in which the ground planes of the first and second transistors are separated from the semiconductive substrate layer (101) by a first well (N-w) forming a band and having doping of a first type, the first well being supplied by a first voltage level, the integrated circuit additionally comprising tenth and eleventh transistors (203, 207) of a type that is the opposite of the first and second transistors, the tenth and eleventh transistors being adjoined and having ground planes of opposite doping types, the ground planes of the tenth and eleventh transistors being separated from the semiconductive substrate layer by a second well (P-w) that is adjoined to the first well and forming a band, the second well having a second doping type that is the opposite of the first type, the second well being supplied by a second voltage level, the first and tenth transistors having respective gates whose work functions are separate, the second and eleventh transistors having respective gates whose work functions are separate.

24. Integrated circuit according to Claim 23, in which the first (205) and tenth (203) transistors are adjoined and belong to one and the same logic gate, and in which the second (213) and eleventh (207) transistors are adjoined and belong to one and the same logic gate, and in which the doping type of the ground plane of the first transistor is the opposite of the doping type of the ground plane of the tenth transistor, and in which the first and second transistors have respective gates whose work functions are separate.

EP 2 415 079 B1

## Fig.1

WL

INV1

VDD

T    F

INV2

VDD

TA$_T$    TA$_F$

BL$_T$    BL$_F$

## Fig.2

1

106    105    111    108    107

110

S    D

101    104    102    103

## Fig.3

nMOS

V$_T$ (mV) [V$_{DS}$=0.1V]

700
600
500
400
300
200
100
0

0    50    100    150    T$_{BOX}$(nm)

- GP-p (Vbg-s=0V)
- GP-p (Vbg-s=Vdd)
- W/O GP

nMOS

V$_T$ (mV) [V$_{DS}$=0.1V]

700
600
500
400
300
200
100
0

0    50    100    150    T$_{BOX}$(nm)

- GP-n (Vbg-s=0V)
- GP-n (Vbg-s=Vdd)
- W/O GP

V$_{DD}$=1V    L$_G$=45nm    T$_{Si}$=8nm    N$_{GP}$=10$^{18}$cm$^{-3}$

## Fig.4

| V$_{BG-S}$ | 0 V | V$_{DD}$ |
|---|---|---|
| **GP-n** | V$_T$ | V$_{TL}$ |
| **GP-p** | V$_{TH}$ | V$_T$ |

nMOS

| V$_{BG-S}$ | 0 V | \|V$_{DD}$\| |
|---|---|---|
| **GP-n** | V$_{TH}$ | V$_T$ |
| **GP-p** | V$_T$ | V$_{TL}$ |

pMOS

## Fig.5

- GP-p (Vbg-s=0V)
- GP-p (Vbg-s=Vdd)
- GP-n (Vbg-s=0V)
- GP-n (Vbg-s=Vdd)
- W/O GP

## Fig.6

- GP-p (Vbg-s=0V)
- GP-p (Vbg-s=Vdd)
- GP-n (Vbg-s=0V)
- GP-n (Vbg-s=Vdd)
- W/O GP

## Fig.7

Fig.8

Fig.9

Fig.10

Fig.11

|  | 4T |
|---|---|
| S ($\mu m^2$) | 0.224 |
| $I_{CELL}$ ($\mu A$) | 17.1 |
| $I_{LEAK}$ (pA) | 12.9 |
| NBL | $10^6$ |
| SNM (mV) | 205 |
| RNM (mV) | 209 |
| WM (mV) | 224 |

Fig.12

Fig.13

Fig.14

Fig.16

Fig.17

Fig.18

| | | | | |
|---|---|---|---|---|
| ▨ Métal 1 | | ▨ Zone de diffusion | | |
| ▨ Grille | | ⊠ Contact | | Fig.15 |

**Fig.20**

| | | | |
|---|---|---|---|
| ▨ M1 | ▨ Zd | | |
| ▨ Gr  53 | ⊠ Ct | ▭ Sn | |

Fig.19

Fig.21

Fig.22

Fig.24

Fig.23

| Pattern | Label |
|---|---|
| ▨ | M1 |
| ▥ | Zd |
| ▨ | Gr |
| ⊠ | Ct |
| ▭ | Sn |

Fig.25

| Pattern | Label |
|---|---|
| ⊠ | Ps |
| ▭ | Met |
| ▯ | Zdif |
| ▨ | G |
| ▣ | Ct |

Fig.26

Fig.27

SubN

Fig.28

Fig.29

Fig. 30

Fig. 31

Fig. 32

Fig. 33

VDD

301

A          Z          300

302

EN

303

Fig. 34

301
Vdd

EN          N-W

A

P-W

Z    302    303    Gnd

Gp-p
Gp-n
Ga-n
Ga-p
Al

Fig. 35

Fig. 36

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- US 6442060 B
- US 6063886 A